(19) Europäisches Patentamt
European Patent Office
Office européen des brevets

(11) EP 4 168 418 B1

(12) EUROPEAN PATENT SPECIFICATION

(45) Date of publication and mention of the grant of the patent:
**27.05.2026 Bulletin 2026/22**

(21) Application number: **21739259.6**

(22) Date of filing: **16.06.2021**

(51) International Patent Classification (IPC):
***C07F 5/02*** *(2006.01)* ***C09K 11/06*** *(2006.01)*
***H10K 85/60*** *(2023.01)*

(52) Cooperative Patent Classification (CPC):
**C07F 5/027; C09K 11/06; H10K 85/658;**
C09K 2211/1007; C09K 2211/104; H10K 50/11;
Y02E 10/549

(86) International application number:
**PCT/EP2021/066197**

(87) International publication number:
**WO 2021/255073 (23.12.2021 Gazette 2021/51)**

(54) **ORGANIC MOLECULES FOR OPTOELECTRONIC DEVICES**
ORGANISCHE MOLEKÜLE FÜR OPTOELEKTRONISCHE VORRICHTUNGEN
MOLÉCULES ORGANIQUES POUR DISPOSITIFS OPTOÉLECTRONIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.06.2020 EP 20180685**

(43) Date of publication of application:
**26.04.2023 Bulletin 2023/17**

(73) Proprietor: **Samsung Display Co., Ltd.**
**Yongin-si, Gyeonggi-do 17113 (KR)**

(72) Inventors:
- **SEIFERMANN, Stefan**
  **77815 Bühl (DE)**
- **ZINK, Daniel**
  **76676 Graben-Neudorf (DE)**
- **DÜCK, Sebastian**
  **69115 Heidelberg (DE)**

(74) Representative: **Dr. Weitzel & Partner**
**Patent- und Rechtsanwälte mbB**
**Friedenstrasse 10**
**89522 Heidenheim (DE)**

(56) References cited:
**WO-A1-2020/184834 WO-A1-2021/020941**
**WO-A1-2021/020943 WO-A1-2021/020947**
**WO-A1-2021/049889 WO-A1-2021/073385**
**US-A1- 2020 176 679**

- **XIAO LIANG ET AL: "Peripheral Amplification of Multi-Resonance Induced Thermally Activated Delayed Fluorescence for Highly Efficient OLEDs", ANGEWANDTE CHEMIE INTERNATIONAL EDITION, VERLAG CHEMIE, HOBOKEN, USA, vol. 57, no. 35, 30 July 2018 (2018-07-30), pages 11316 - 11320, XP072099880, ISSN: 1433-7851, DOI: 10.1002/ANIE.201806323**
- **LEE S U: "Preparation of fused boron-containing polycyclic compounds for organic electroluminescent device", US2020176679 A1, 4 June 2020 (2020-06-04), pages 1 - 9, XP055835074**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 168 418 B1

## Description

The invention relates to organic light-emitting molecules and their use in organic light-emitting diodes (OLEDs) and in other optoelectronic devices.

## State of the art

US 2020/176679 A1 relates to a compound represented by formula 1

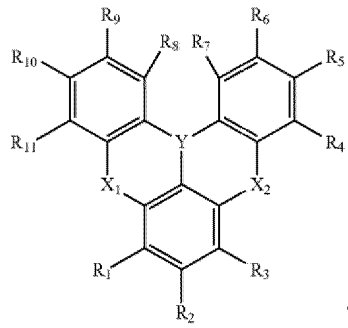

formula 1,

wherein $R_1$ to $R_{11}$, Y, $X_1$ and $X_2$ are defined as disclosed in US 2020/176679 A1 and an organic electroluminescent element including the same, and provides an organic compound which is excellent in service life, efficiency, electrochemical stability, and thermal stability, and an organic electroluminescent element including the same.

WO 2021/073385 A1 describes an organic compound, having a structure of the following formula (1),

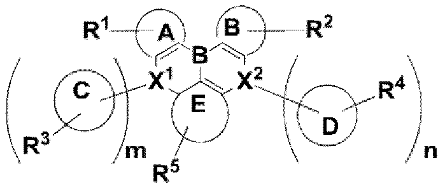

(1) ,

wherein A to E, $R_1$ to $R^5$, $X^1$, $X^2$, n and m are defined as disclosed in WO 2021/073385 A1, and an organic electroluminescent device using the compound.

WO 2021/049889 A1 is directed to a compound represented by chemical formula 1, and an organic light-emitting device comprising same,

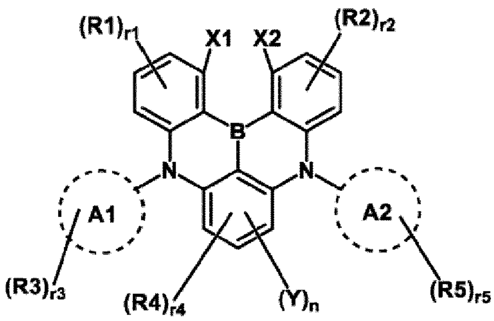

formula 1.

In the compounds of formula 1 A1, A2, R1 to R5, X1, X2, Y, r1 to r5 and n are defined as disclosed in WO 2021/049889 A1.

WO 2021/020947 A1, WO 2021/020943 A1 and WO 2021/020941 A1 disclose organic light-emitting devices comprising a compound represented by chemical formula 1,

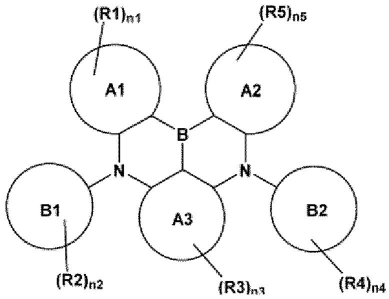

wherein A1, A2, A3, B1, B2, R1 to R5 and n1 to n5 are defined as disclosed in WO 2021/020947 A1, WO 2021/020943 A1 and WO 2021/020941 A1.

WO 2020/184834 A1 relates to a compound represented by chemical formula 1 and an organic light emitting device comprising same.

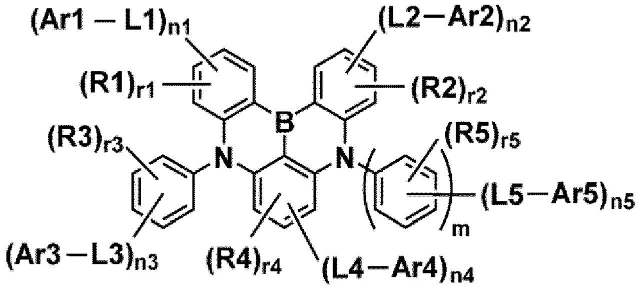

formula 1

In the compounds of formula 1 Ar1-L1, L2-Ar2, Ar3-L3, L4-Ar4, L5-Ar5, R1 to R5 and r1 to r5 and n1 to n5 are defined as disclosed in WO 2020/184834 A1.

Xiao Liang et al.: "Peripheral Amplification of Multi-Resonance Induced Thermally Activated Delayed Fluorescence for Highly Efficient OLEDs", Angewandte Chemie International Edition, vol. 57, no. 35, 30 July 2018, pages 11316-11320 describes devices fabricated using the emitter compounds DABNA-1 and DABNA-2 which exhibit despite the high external quantum efficiency and good color purity, poor stability with a sharp drop in efficiency roll-off.

## Description

The object of the present invention is to provide molecules which are suitable for use in optoelectronic devices.

This object is achieved by the invention which provides a new class of organic molecules.

According to the invention the organic molecules are purely organic molecules, i.e. they do not contain any metal ions in contrast to metal complexes known for the use in optoelectronic devices. The organic molecules of the invention, however, include metalloids, in particular B, Si, Sn, Se, and/or Ge.

According to the present invention, the organic molecules exhibit emission maxima in the blue, sky-blue or green spectral range. The organic molecules exhibit in particular emission maxima between 420 nm and 520 nm, preferably between 440 nm and 495 nm, more preferably between 450 nm and 470 nm. The photoluminescence quantum yields of the organic molecules according to the invention are, in particular, 50 % or more. The use of the molecules according to the invention in an optoelectronic device, for example an organic light-emitting diode (OLED), leads to higher efficiencies or higher color purity, expressed by the full width at half maximum (FWHM) of emission, of the device. Corresponding OLEDs have a higher stability than OLEDs with known emitter materials and comparable color.

The organic light-emitting molecules according to the invention consist of a structure of formula II-1,

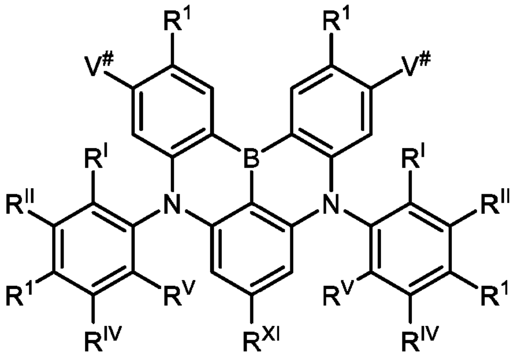

Formula II-1

wherein

$V^{\#}$ is selected from the group consisting of
hydrogen,
deuterium,
$C_1$-$C_5$-alkyl; and
Ph, which is optionally substituted with one or more substituents independently from each other selected from the group consisting of Me, $^{i}$Pr, $^{t}$Bu, and Ph;
wherein
$R^1$ consists of a structure of the following formula F

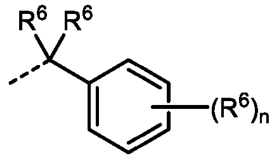

Formula F

wherein n is an integer, which is at each occurrence selected from the group consisting of 0, 1, 2, 3, 4 and 5; and the dotted line representing the position at which it is bonded to the structure shown in formula II-1;
$R^6$ is at each occurrence independently from each other selected from the group consisting of: hydrogen, deuterium, and
$C_1$-$C_5$-alkyl;
$R^I$, $R^{II}$, $R^{IV}$, and $R^V$ is independently from another selected from the group consisting of:

$R^1$,
hydrogen,
deuterium,
$N(R^5)_2$,
$OR^5$,
$SR^5$,
$Si(R^5)_3$,
$B(OR^5)_2$,
$OSO_2R^5$,
$CF_3$,
CN,
halogen,
$C_1$-$C_{40}$-alkyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkenyl,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkynyl,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,
which is optionally substituted with one or more substituents $R^5$; and
$C_3$-$C_{57}$-heteroaryl,
which is optionally substituted with one or more substituents $R^5$;
$R^5$ is at each occurrence independently from another selected from the group consisting of: hydrogen, deuterium, OPh (Ph = phenyl), SPh, $CF_3$, CN, **F,** $Si(C_1\text{-}C_5\text{-alkyl})_3$, $Si(Ph)_3$,
$C_1$-$C_5$-alkyl,
wherein optionally one or more hydrogen atoms are independently from each other substituted by deuterium, CN, $CF_3$, or F;
$C_1$-$C_5$-alkoxy,
wherein optionally one or more hydrogen atoms are independently from each other substituted by deuterium, CN, $CF_3$, or F;
$C_1$-$C_5$-thioalkoxy,
wherein optionally one or more hydrogen atoms are independently from each other substituted by deuterium, CN, $CF_3$, or F;
$C_2$-$C_5$-alkenyl,
wherein optionally one or more hydrogen atoms are independently from each other substituted by deuterium, CN, $CF_3$, or F;
$C_2$-$C_5$-alkynyl,
wherein optionally one or more hydrogen atoms are independently from each other substituted by deuterium, CN, $CF_3$, or F;
$C_6$-$C_{18}$-aryl,
which is optionally substituted with one or more $C_1$-$C_5$-alkyl substituents;
$C_3$-$C_{17}$-heteroaryl,
which is optionally substituted with one or more $C_1$-$C_5$-alkyl substituents;
$N(C_6\text{-}C_{18}\text{-aryl})_2$,
$N(C_3\text{-}C_{17}\text{-heteroaryl})_2$; and
$N(C_3\text{-}C_{17}\text{-heteroaryl})(C_6\text{-}C_{18}\text{-aryl})$.
$R^{XI}$ is selected from the group consisting of hydrogen, chloride and $C_1$-$C_5$ alkyl.

The organic molecule of the invention has at least two groups with a structure of formula F, but may have up to 12 groups with a structure of formula F. Certain embodiments of the organic molecule have two or four groups with a structure of formula F.

Depending on the value of the integer n, $R^1$ may have a structure as shown below:

for n = 0:

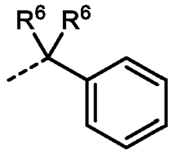 ,

for n = 1:

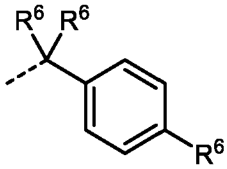 , 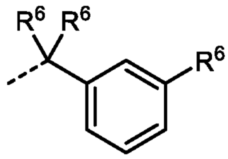 , 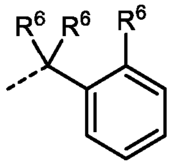 ,

for n = 2:

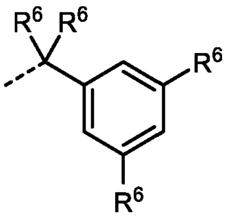 , 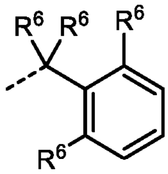 , 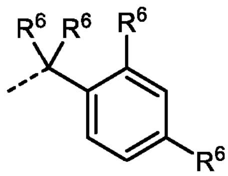 , 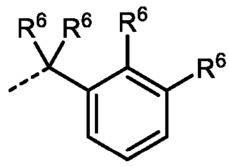 ,

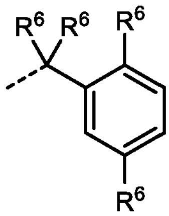 , 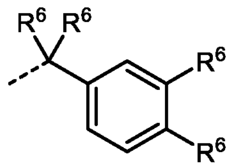 ,

for n = 3:

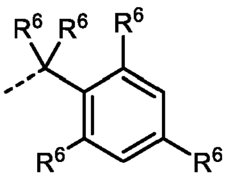 , 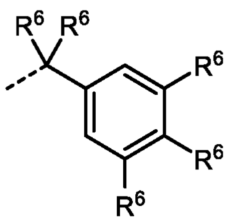 , 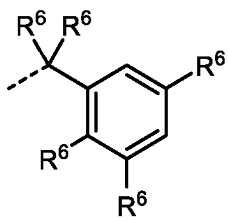 , 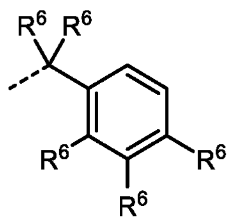 ,

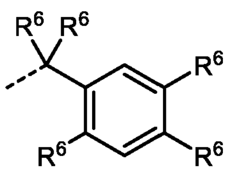 , 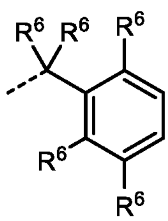 ,

for n = 4

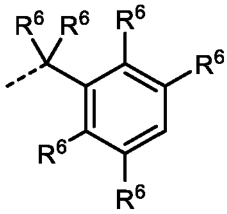, 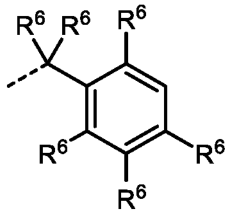, 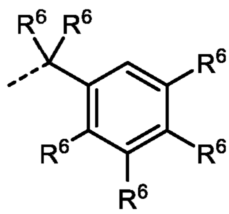,

for n = 5

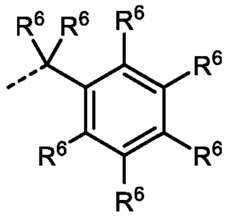

wherein $R^6$ is at each occurrence independently from each other selected from the group consisting of: hydrogen, deuterium, and $C_1$-$C_5$-alkyl, wherein, in certain embodiments, the $C_1$-$C_5$-alkyl group may be Me, $^i$Pr, $^t$Bu, or neo-pentyl.

In certain embodiments, $R^6$ is at each occurrence independently from each other selected from the group consisting of: hydrogen, deuterium, Me, $^i$Pr, $^t$Bu, and neo-pentyl.

In other embodiments, $R^6$ is at each occurrence independently from each other selected from the group consisting of: hydrogen and Me.

In a preferred embodiment, $R^1$ is at each occurrence of the group consisting of formula $R^{1a}$ and formula $R^{1b}$:

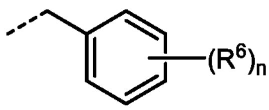,

Formula $R^{1a}$

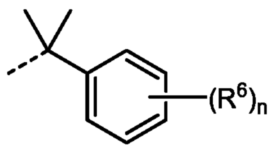

Formula $R^{1b}$.

Specific examples of $R^1$ include for example:

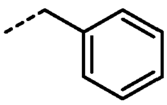, 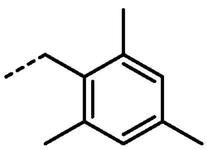, 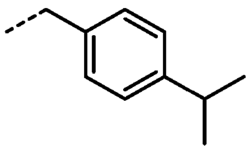, 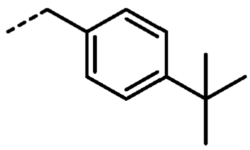, 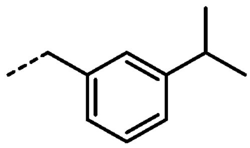,

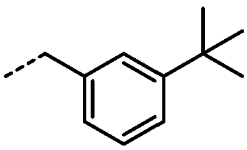, 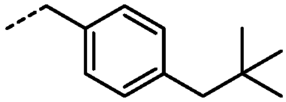, 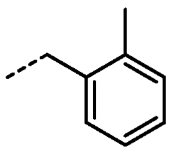, 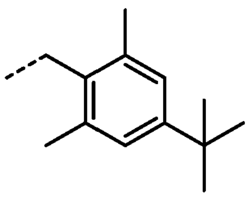,

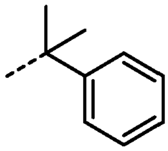,
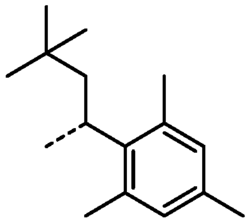,
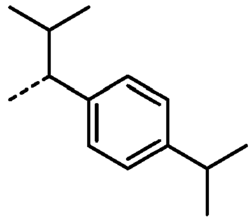.

In one particularly preferred embodiment, $R^1$ is selected from the group consisting of formula $R^{1c}$ and formula $R^{1d}$:

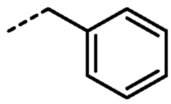,
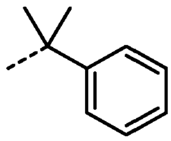

Formula $R^{1c}$ Formula $R^{1d}$.

In one embodiment, $R^{XI}$ is selected from the group of hydrogen, Me, $^i$Pr and $^t$Bu.

In one embodiment, $R^{XI}$ is selected from the group of hydrogen or Me.

In one embodiment, $R^{XI}$ is hydrogen.

In one embodiment, $R^{XI}$ is chloride.

In one embodiment, $R^{XI}$ is Me.

In one embodiment of the organic molecule, $R^I$, $R^{II}$, $R^{IV}$, and $R^V$ is independently from another selected from the group consisting of:

$R^1$,
hydrogen, deuterium, halogen, Me, $^i$Pr, $^t$Bu, CN, $CF_3$, $SiMe_3$, $SiPh_3$,
Ph, which is optionally substituted with one or more substituents independently from each other selected from the group consisting of Me, $^i$Pr, $^t$Bu, CN, $CF_3$, and Ph,
pyridinyl, which is optionally substituted with one or more substituents independently from each other selected from the group consisting of Me, $^i$Pr, $^t$Bu, CN, $CF_3$, and Ph,
pyrimidinyl, which is optionally substituted with one or more substituents independently from each other selected from the group consisting of Me, $^i$Pr, $^t$Bu, CN, $CF_3$, and Ph,
carbazolyl, which is optionally substituted with one or more substituents independently from each other selected from the group consisting of Me, $^i$Pr, $^t$Bu, CN, $CF_3$, and Ph,
triazinyl, which is optionally substituted with one or more substituents independently from each other selected from the group consisting of Me, $^i$Pr, $^t$Bu, CN, $CF_3$, and Ph,
and $N(Ph)_2$.

In one embodiment, $R^I$, $R^{II}$, $R^{IV}$, and $R^V$ is independently from another selected from the group consisting of:

$R^1$,
hydrogen, deuterium, halogen, Me, $^i$Pr, $^t$Bu, CN, $CF_3$,
Ph, which is optionally substituted with one or more substituents independently from each other selected from the group consisting of Me, $^i$Pr, $^t$Bu, CN, $CF_3$, and Ph,
pyridinyl, which is optionally substituted with one or more substituents independently from each other selected from the group consisting of Me, $^i$Pr, $^t$Bu, CN, $CF_3$, and Ph,
pyrimidinyl, which is optionally substituted with one or more substituents independently from each other selected from the group consisting of Me, $^i$Pr, $^t$Bu, CN, $CF_3$, and Ph,
carbazolyl, which is optionally substituted with one or more substituents independently from each other selected from the group consisting of Me, $^i$Pr, $^t$Bu, CN, $CF_3$, and Ph,
triazinyl, which is optionally substituted with one or more substituents independently from each other selected from the group consisting of Me, $^i$Pr, $^t$Bu, CN, $CF_3$, and Ph,
and $N(Ph)_2$.

In one embodiment, $R^I$, $R^{II}$, $R^{IV}$, and $R^V$ is independently from another selected from the group consisting of:

$R^1$, hydrogen, deuterium, halogen, Me, $^i$Pr, $^t$Bu, CN, $CF_3$,
Ph, which is optionally substituted with one or more substituents independently from each other selected from the group consisting of Me, $^i$Pr, $^t$Bu, CN, $CF_3$, and Ph,
pyridinyl, which is optionally substituted with one or more substituents independently from each other selected from the group consisting of Me, $^i$Pr, $^t$Bu, CN, $CF_3$, and Ph,
pyrimidinyl, which is optionally substituted with one or more substituents independently from each other selected from the group consisting of Me, $^i$Pr, $^t$Bu, CN, $CF_3$, and Ph, and
triazinyl, which is optionally substituted with one or more substituents independently from each other selected from the group consisting of Me, $^i$Pr, $^t$Bu, CN, $CF_3$, and Ph,
and $N(Ph)_2$.

In one embodiment, $R^I$, $R^{II}$, $R^{IV}$, and $R^V$ is independently from another selected from the group consisting of: $R^1$, hydrogen, deuterium, Me, $^i$Pr, $^t$Bu,

Ph, which is optionally substituted with one or more substituents independently from each other selected from the group consisting of Me, $^i$Pr, $^t$Bu, and Ph,
carbazolyl, which is optionally substituted with one or more substituents independently from each other selected from the group consisting of Me, $^i$Pr, $^t$Bu, CN, $CF_3$, and Ph,
and $N(Ph)_2$.

In one embodiment $R^I$, $R^{II}$, $R^{IV}$, and $R^V$ is independently from another selected from the group consisting of: $R^1$, hydrogen, deuterium, Me, $^i$Pr, $^t$Bu,

Ph, which is optionally substituted with one or more substituents independently from each other selected from the group consisting of Me, $^i$Pr, $^t$Bu, and Ph,
and $N(Ph)_2$.

In one embodiment, $R^I$, $R^{II}$, $R^{IV}$, and $R^V$ is independently from another selected from the group consisting of: $R^1$, hydrogen, deuterium, Me, $^i$Pr, $^t$Bu,

Ph, which is optionally substituted with one or more substituents independently from each other selected from the group consisting of Me, $^i$Pr, $^t$Bu, and Ph,
and $N(Ph)_2$.

In one embodiment, $R^I$, $R^{II}$, $R^{IV}$, and $R^V$ is independently from another selected from the group consisting of: $R^1$, hydrogen, $^t$Bu, and Ph.

In the invention, the organic molecules consist of a structure of formula II-1:

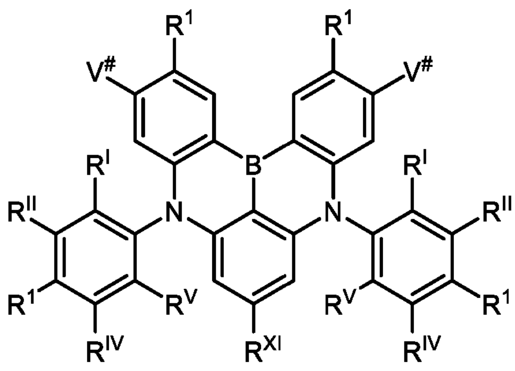

Formula II-1

Examples of the organic molecules according to the invention, which consist of a structure of formula II-1:

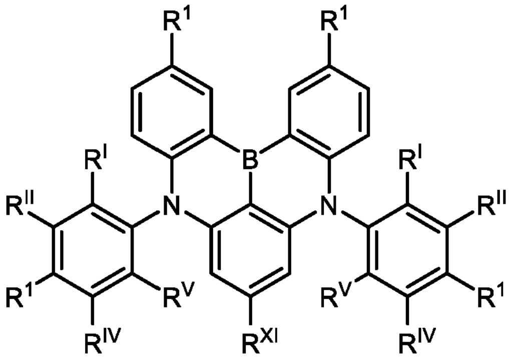,

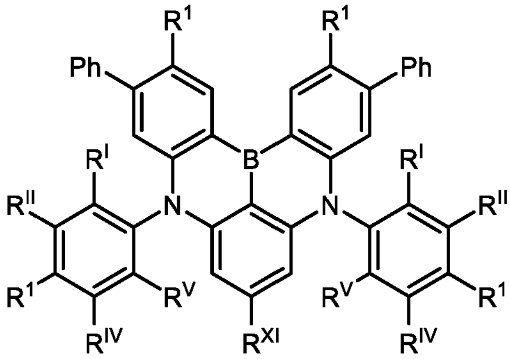,

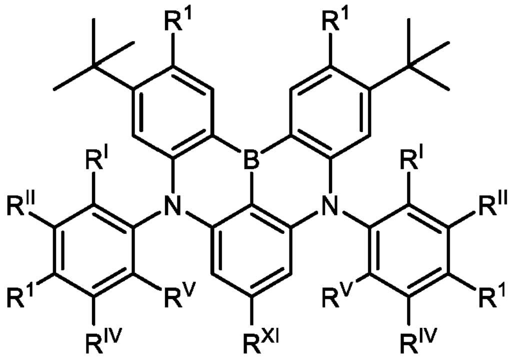,

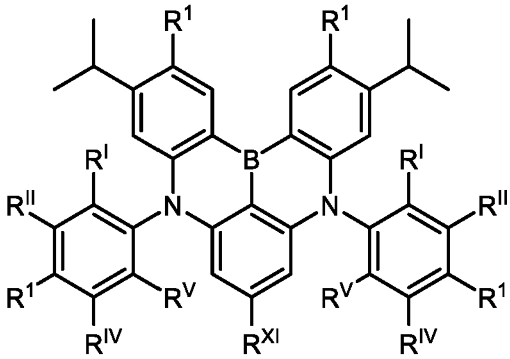,

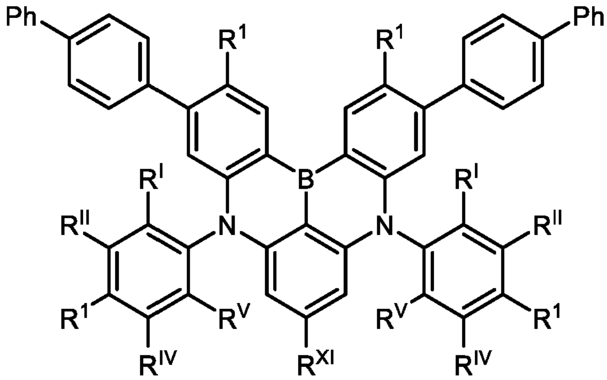.

In a preferred embodiment, the organic molecules comprise or consist of a structure of formula IIIa-1 :

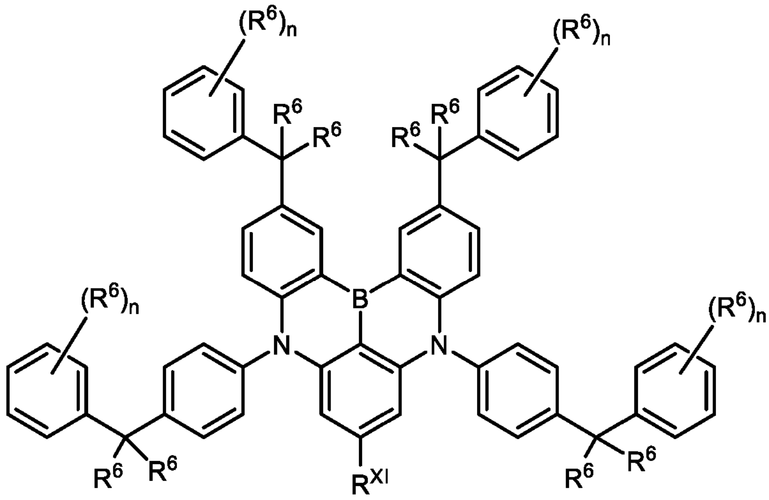

Formula IIIa-1

In one embodiment, the organic molecule comprises or consists of a structure selected from the group consisting of formula IV-1 and formula IV-2:

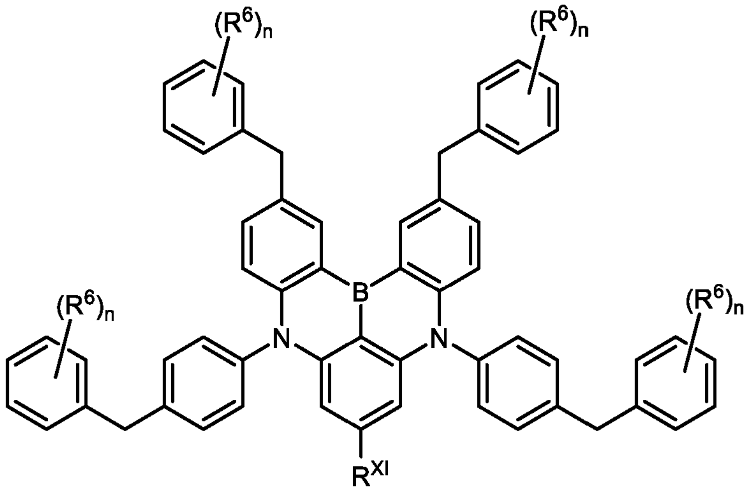

Formula IV-1

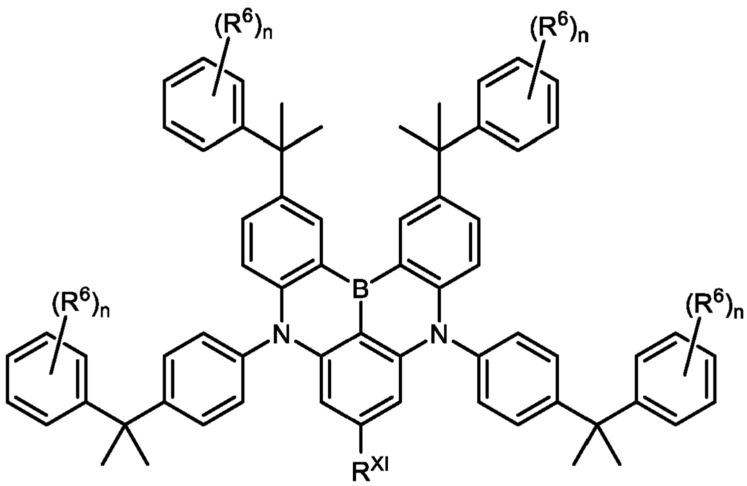

Formula IV-2.

In one embodiment, the organic molecule comprises or consists of a structure selected from the group consisting of formula IVa and formula IVb:

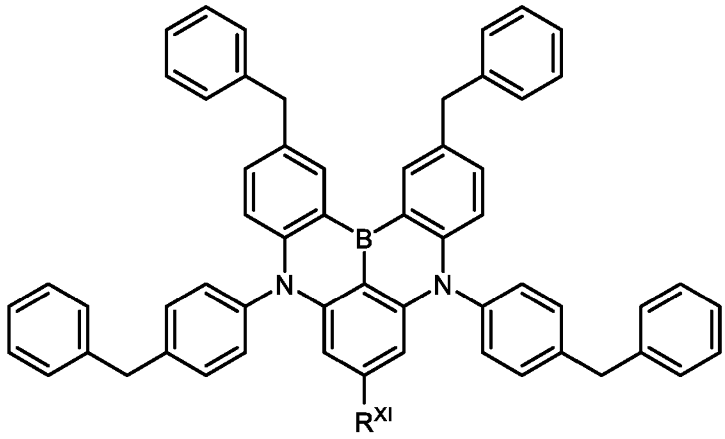

Formula IVa

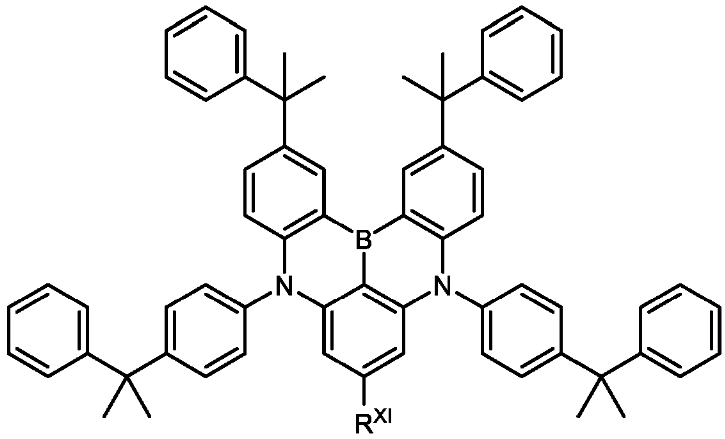

Formula IVb.

As used throughout the present application, the terms "aryl" and "aromatic" may be understood in the broadest sense as any mono-, bi- or polycyclic aromatic moieties. Accordingly, an aryl group contains 6 to 60 aromatic ring atoms, and a heteroaryl group contains 5 to 60 aromatic ring atoms, of which at least one is a heteroatom. Notwithstanding, throughout the application the number of aromatic ring atoms may be given as subscripted number in the definition of certain substituents. In particular, the heteroaromatic ring includes one to three heteroatoms. Again, the terms "heteroaryl" and "heteroaromatic" may be understood in the broadest sense as any mono-, bi- or polycyclic hetero-aromatic moieties that include at least one heteroatom. The heteroatoms may at each occurrence be the same or different and be individually selected from the group consisting of N, O and S. Accordingly, the term "arylene" refers to a divalent substituent that bears two binding sites to other molecular structures and thereby serving as a linker structure. In case, a group in the exemplary embodiments is defined differently from the definitions given here, for example, the number of aromatic ring atoms or number of heteroatoms differs from the given definition, the definition in the exemplary embodiments is to be applied. According to the invention, a condensed (annulated) aromatic or heteroaromatic polycycle is built of two or more single aromatic or heteroaromatic cycles, which formed the polycycle via a condensation reaction.

In particular, as used throughout, the term "aryl group or heteroaryl group" comprises groups which can be bound via any position of the aromatic or heteroaromatic group, derived from benzene, naphthaline, anthracene, phenanthrene, pyrene, dihydropyrene, chrysene, perylene, fluoranthene, benzanthracene, benzphenanthrene, tetracene, pentacene, benzpyrene, furan, benzofuran, isobenzofuran, dibenzofuran, thiophene, benzothiophene, isobenzothiophene, dibenzothiophene; pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthoimidazole, phenanthroimidazole, pyridoimidazole, pyrazinoimidazole, quinoxalinoimidazole, oxazole, benzoxazole, napthooxazole, anthroxazol, phenanthroxazol, isoxazole, 1,2-thiazole, 1,3-thiazole, benzothiazole, pyridazine, benzopyridazine, pyrimidine, benzopyrimidine, 1,3,5-triazine, quinoxaline, pyrazine, phenazine, naphthyridine, carboline, benzocarboline, phenanthroline, 1,2,3-triazole, 1,2,4-triazole, benzotriazole, 1,2,3-oxadiazole, 1,2,4-oxadiazole, 1,2,5-oxadiazole, 1,2,3,4-tetrazine, purine, pteridine, indolizine and benzothiadiazole or combinations of the abovementioned groups.

As used throughout, the term "cyclic group" may be understood in the broadest sense as any mono-, bi- or polycyclic moieties.

As used throughout, the term "biphenyl" as a substituent may be understood in the broadest sense as ortho-biphenyl, meta-biphenyl, or para-biphenyl, wherein ortho, meta and para is defined in regard to the binding site to another chemical moiety.

As used throughout, the term "alkyl group" may be understood in the broadest sense as any linear, or branched alkyl substituent. In particular, the term alkyl comprises the substituents methyl (Me), ethyl (Et), n-propyl ("Pr), i-propyl ($^{i}$Pr), cyclopropyl, n-butyl ("Bu), i-butyl ($^{i}$Bu), s-butyl ($^{s}$Bu), t-butyl ($^{t}$Bu), 2-methylbutyl, n-pentyl, s-pentyl, t-pentyl, 2-pentyl, neopentyl, n-hexyl, s-hexyl, t-hexyl, 2-hexyl, 3-hexyl, neo-hexyl, 2-methylpentyl, n-heptyl, 2-heptyl, 3-heptyl, 4-heptyl, n-octyl, 2-ethylhexyl, 2-(2,6-dimethyl)octyl, 3-(3,7-dimethyl)octyl, 1,1-dimethyl-n-hex-1-yl, 1,1-dimethyl-n-hept-1-yl, 1,1-dimethyl-n-oct-1-yl, 1,1-dimethyl-n-dec-1-yl, 1,1-dimethyl-n-dodec-1-yl, 1,1-dimethyl-n-tetradec-1-yl, 1,1-dimethyl-n-hexadec-1-yl, 1,1-dimethyl-n-octadec-1-yl, 1,1-diethyl-n-hex-1-yl, 1,1-diethyl-n-hept-1-yl, 1,1-diethyl-n-oct-1-yl, 1,1-diethyl-n-dec-1-yl, 1,1-diethyl-n-dodec-1-yl, 1,1-diethyl-n-tetradec-1-yl, 1,1-diethyln-n-hexadec-1-yl, 1,1-diethyl-n-octadec-1-yl.

As used throughout, the term "alkenyl" comprises linear, and branched alkenyl substituents. The term "alkenyl group", for example, comprises the substituents ethenyl, propenyl, butenyl, pentenyl, hexenyl, heptenyl, octenyl.

As used throughout, the term "alkynyl" comprises linear, and branched alkynyl substituents. The term "alkynyl group", for example, comprises ethynyl, propynyl, butynyl, pentynyl, hexynyl, heptynyl or octynyl.

As used throughout, the term "alkoxy" comprises linear, and branched alkoxy substituents. The term "alkoxy group" exemplarily comprises methoxy, ethoxy, n-propoxy, i-propoxy, n-butoxy, i-butoxy, s-butoxy, t-butoxy and 2-methylbutoxy.

As used throughout, the term "thioalkoxy" comprises linear, and branched thioalkoxy substituents, in which the O of the exemplarily alkoxy groups is replaced by S.

As used throughout, the terms "halogen" and "halo" may be understood in the broadest sense as being preferably fluorine, chlorine, bromine or iodine.

Whenever hydrogen (H) is mentioned herein, it could also be replaced by deuterium at each occurrence.

It is understood that when a molecular fragment is described as being a substituent or otherwise attached to another moiety, its name may be written as if it were a fragment (e.g. naphtyl, dibenzofuryl) or as if it were the whole molecule (e.g. naphthalene, dibenzofuran). As used herein, these different ways of designating a substituent or attached fragment are considered to be equivalent.

In one embodiment, the organic molecules according to the invention have an excited state lifetime of not more than 150 $\mu$s, of not more than 100 $\mu$s, in particular of not more than 50 $\mu$s, more preferably of not more than 10 $\mu$s or not more than 7 $\mu$s in a film of poly(methyl methacrylate) (PMMA) with 2 % by weight of organic molecule at room temperature.

In a further embodiment of the invention, the organic molecules according to the invention have an emission peak in the visible or nearest ultraviolet range, i.e., in the range of a wavelength of from 380 nm to 800 nm, with a full width at half maximum of less than 0.23 eV, preferably less than 0.20 eV, more preferably less than 0.19 eV, even more preferably less than 0.18 eV or even less than 0.17 eV in a film of poly(methyl methacrylate) (PMMA) with 2 % by weight of organic molecule at room temperature.

Orbital and excited state energies can be determined either by means of experimental methods. The energy of the highest occupied molecular orbital $E^{HOMO}$ is determined by methods known to the person skilled in the art from cyclic voltammetry measurements with an accuracy of 0.1 eV. The energy of the lowest unoccupied molecular orbital $E^{LUMO}$ is calculated as $E^{HOMO} + E^{gap}$, wherein $E^{gap}$ is determined as follows: For host compounds, the onset of the emission spectrum of a film with 10 % by weight of host in poly(methyl methacrylate) (PMMA) is used as $E^{gap}$, unless stated otherwise. For emitter molecules, $E^{gap}$ is determined as the energy at which the excitation and emission spectra of a film with 10 % by weight of emitter in PMMA cross. For the organic molecules according to the invention, $E^{gap}$ **is** determined as the energy at which the excitation and emission spectra of a film with 2 % by weight of emitter in PMMA cross.

The energy of the first excited triplet state T1 is determined from the onset of the emission spectrum at low temperature, typically at 77 K. For host compounds, where the first excited singlet state and the lowest triplet state are energetically separated by > 0.4 eV, the phosphorescence is usually visible in a steady-state spectrum in 2-Me-THF. The triplet energy can thus be determined as the onset of the phosphorescence spectrum. For TADF emitter molecules, the energy of the first excited triplet state T1 is determined from the onset of the delayed emission spectrum at 77 K, if not otherwise stated, measured in a film of PMMA with 10 % by weight of emitter and in case of the organic molecules according to the invention with 2 % by weight of the organic molecules according to the invention. Both for host and emitter compounds, the energy of the first excited singlet state S1 is determined from the onset of the emission spectrum, if not otherwise stated, measured in a film of PMMA with 10 % by weight of host or emitter compound and in case of the organic

molecules according to the invention with 2 % by weight of the organic molecules according to the invention.

The onset of an emission spectrum is determined by computing the intersection of the tangent to the emission spectrum with the x-axis. The tangent to the emission spectrum is set at the high-energy side of the emission band and at the point at half maximum of the maximum intensity of the emission spectrum.

In one embodiment, the organic molecules according to the invention have an onset of the emission spectrum, which is energetically close to the emission maximum, i.e. the energy difference between the onset of the emission spectrum and the energy of the emission maximum is below 0.14 eV, preferably below 0.13 eV, or even below 0.12 eV, while the full width at half maximum (FWHM) of the organic molecules is less than 0.23 eV, preferably less than 0.20 eV, more preferably less than 0.19 eV, even more preferably less than 0.18 eV or even less than 0.17 eV in a film of poly(methyl methacrylate) (PMMA) with 2 % by weight of organic molecule at room temperature, resulting in a CIEy coordinate below 0.20, preferably below 0.18, more preferably below 0.16 or even more preferred below 0.14.

A further aspect of the invention relates to the use of an organic molecule of the invention as a luminescent emitter or as an absorber, and/or as a host material and/or as an electron transport material, and/or as a hole injection material, and/or as a hole blocking material in an optoelectronic device.

A preferred embodiment relates to the use of an organic molecule according to the invention as a luminescent emitter in an optoelectronic device.

The optoelectronic device may be understood in the broadest sense as any device based on organic materials that is suitable for emitting light in the visible or nearest ultraviolet (UV) range, i.e., in the range of a wavelength of from 380 to 800 nm. More preferably, the optoelectronic device may be able to emit light in the visible range, i.e., of from 400 nm to 800 nm.

In the context of such use, the optoelectronic device is more particularly selected from the group consisting of:

- organic light-emitting diodes (OLEDs),
- light-emitting electrochemical cells,
- OLED sensors, especially in gas and vapor sensors that are not hermetically shielded to the surroundings,
- organic diodes,
- organic solar cells,
- organic transistors,
- organic field-effect transistors,
- organic lasers, and
- down-conversion elements.

In a preferred embodiment in the context of such use, the optoelectronic device is a device selected from the group consisting of an organic light emitting diode (OLED), a light emitting electrochemical cell (LEC), and a light-emitting transistor.

In the case of the use, the fraction of the organic molecule according to the invention in the emission layer in an optoelectronic device, more particularly in an OLED, is 0.1 % to 99 % by weight, more particularly 1 % to 80 % by weight. In an alternative embodiment, the proportion of the organic molecule in the emission layer is 100 % by weight.

In one embodiment, the light-emitting layer comprises not only the organic molecules according to the invention, but also a host material whose triplet (T1) and singlet (S1) energy levels are energetically higher than the triplet (T1) and singlet (S1) energy levels of the organic molecule.

A further aspect of the invention relates to a composition comprising or consisting of:

(a) at least one organic molecule according to the invention, in particular in the form of an emitter and/or a host, and
(b) one or more emitter and/or host materials, which differ from the organic molecule according to the invention and
(c) optional one or more dyes and/or one or more solvents.

In one embodiment, the light-emitting layer comprises (or essentially consists of) a composition comprising or consisting of:

(a) at least one organic molecule according to the invention, in particular in the form of an emitter and/or a host, and
(b) one or more emitter and/or host materials, which differ from the organic molecule according to the invention and
(c) optional one or more dyes and/or one or more solvents.

In a particular embodiment, the light-emitting layer EML comprises (or essentially consists of) a composition comprising or consisting of:

(i) 0.1-10 % by weight, preferably 0.5-5 % by weight, in particular 1-3 % by weight, of one or more organic molecules

according to the invention;

(ii) 5-99 % by weight, preferably 15-85 % by weight, in particular 20-75% by weight, of at least one host compound H; and

(iii) 0.9-94.9 % by weight, preferably 14.5-80 % by weight, in particular 24-77 % by weight, of at least one further host compound D with a structure differing from the structure of the molecules according to the invention; and

(iv) optionally 0-94 % by weight, preferably 0-65 % by weight, in particular 0-50 % by weight, of a solvent; and

(v) optionally 0-30 % by weight, in particular 0-20 % by weight, preferably 0-5 % by weight, of at least one further emitter molecule F with a structure differing from the structure of the molecules according to the invention.

Preferably, energy can be transferred from the host compound H to the one or more organic molecules according to the invention, in particular transferred from the first excited triplet state T1(H) of the host compound H to the first excited triplet state T1(E) of the one or more organic molecules according to the invention E and/ or from the first excited singlet state S1(H) of the host compound H to the first excited singlet state S1(E) of the one or more organic molecules according to the invention E.

In one embodiment, the host compound H has a highest occupied molecular orbital HOMO(H) having an energy $E^{HOMO}(H)$ in the range of from -5 to -6.5 eV and the at least one further host compound D has a highest occupied molecular orbital HOMO(D) having an energy $E^{HOMO}(D)$, wherein $E^{HOMO}(H) > E^{HOMO}(D)$.

In a further embodiment, the host compound H has a lowest unoccupied molecular orbital LUMO(H) having an energy $E^{LUMO}(H)$ and the at least one further host compound D has a lowest unoccupied molecular orbital LUMO(D) having an energy $E^{LUMO}(D)$, wherein $E^{LUMO}(H) > E^{LUMO}(D)$.

In one embodiment, the host compound H has a highest occupied molecular orbital HOMO(H) having an energy $E^{HOMO}(H)$ and a lowest unoccupied molecular orbital LUMO(H) having an energy $E^{LUMO}(H)$, and

the at least one further host compound D has a highest occupied molecular orbital HOMO(D) having an energy $E^{HOMO}(D)$ and a lowest unoccupied molecular orbital LUMO(D) having an energy $E^{LUMO}(D)$,

the organic molecule according to the invention E has a highest occupied molecular orbital HOMO(E) having an energy $E^{HOMO}(E)$ and a lowest unoccupied molecular orbital LUMO(E) having an energy $E^{LUMO}(E)$,

wherein
$E^{HOMO}(H) > E^{HOMO}(D)$ and the difference between the energy level of the highest occupied molecular orbital HOMO(E) of the organic molecule according to the invention E ($E^{HOMO}(E)$) and the energy level of the highest occupied molecular orbital HOMO(H) of the host compound H ($E^{HOMO}(H)$) is between -0.5 eV and 0.5 eV, more preferably between -0.3 eV and 0.3 eV, even more preferably between -0.2 eV and 0.2 eV or even between -0.1 eV and 0.1 eV; and $E^{LUMO}(H) > E^{LUMO}(D)$ and the difference between the energy level of the lowest unoccupied molecular orbital LUMO(E) of the organic molecule according to the invention E ($E^{LUMO}(E)$) and the lowest unoccupied molecular orbital LUMO(D) of the at least one further host compound D ($E^{LUMO}(D)$) is between -0.5 eV and 0.5 eV, more preferably between -0.3 eV and 0.3 eV, even more preferably between -0.2 eV and 0.2 eV or even between -0.1 eV and 0.1 eV.

In one embodiment of the invention the host compound D and/ or the host compound H is a thermally-activated delayed fluorescence (TADF)-material. TADF materials exhibit a $\Delta E_{ST}$ value, which corresponds to the energy difference between the first excited singlet state (S1) and the first excited triplet state (T1), of less than 2500 $cm^{-1}$. Preferably the TADF material exhibits a $\Delta E_{ST}$ value of less than 3000 $cm^{-1}$, more preferably less than 1500 $cm^{-1}$, even more preferably less than 1000 $cm^{-1}$ or even less than 500 $cm^{-1}$.

In one embodiment, the host compound D is a TADF material and the host compound H exhibits a $\Delta E_{ST}$ value of more than 2500 $cm^{-1}$. In a particular embodiment, the host compound D is a TADF material and the host compound H is selected from group consisting of CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole.

In one embodiment, the host compound H is a TADF material and the host compound D exhibits a $\Delta E_{ST}$ value of more than 2500 $cm^{-1}$. In a particular embodiment, the host compound H is a TADF material and the host compound D is selected from group consisting of T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine).

In a further aspect, the invention relates to an optoelectronic device comprising an organic molecule or a composition of the type described here, more particularly in the form of a device selected from the group consisting of organic light-emitting diode (OLED), light-emitting electrochemical cell, OLED sensor, more particularly gas and vapour sensors not hermetically externally shielded, organic diode, organic solar cell, organic transistor, organic field-effect transistor, organic laser and down-conversion element.

In a preferred embodiment, the optoelectronic device is a device selected from the group consisting of an organic light emitting diode (OLED), a light emitting electrochemical cell (LEC), and a light-emitting transistor.

In one embodiment of the optoelectronic device of the invention, the organic molecule according to the invention E is used as emission material in a light-emitting layer EML.

In one embodiment of the optoelectronic device of the invention, the light-emitting layer EML consists of the composition according to the invention described here.

When the optoelectronic device is an OLED, it may, for example, have the following layer structure:

1. substrate
2. anode layer A
3. hole injection layer, HIL
4. hole transport layer, HTL
5. electron blocking layer, EBL
6. emitting layer, EML
7. hole blocking layer, HBL
8. electron transport layer, ETL
9. electron injection layer, EIL
10. cathode layer,

wherein the OLED comprises each layer selected from the group of HIL, HTL, EBL, HBL, ETL, and EIL only optionally, different layers may be merged and the OLED may comprise more than one layer of each layer type defined above.

Furthermore, the optoelectronic device may, in one embodiment, comprise one or more protective layers protecting the device from damaging exposure to harmful species in the environment including, for example, moisture, vapor and/or gases.

In one embodiment of the invention, the optoelectronic device is an OLED, with the following inverted layer structure:

1. substrate
2. cathode layer
3. electron injection layer, EIL
4. electron transport layer, ETL
5. hole blocking layer, HBL
6. emitting layer, B
7. electron blocking layer, EBL
8. hole transport layer, HTL
9. hole injection layer, HIL
10. anode layer A

wherein the OLED comprises each layer selected from the group of HIL, HTL, EBL, HBL, ETL, and EIL only optionally, different layers may be merged and the OLED may comprise more than one layer of each layer types defined above.

In one embodiment of the invention, the optoelectronic device is an OLED, which may have a stacked architecture. In this architecture, contrary to the typical arrangement in which the OLEDs are placed side by side, the individual units are stacked on top of each other. Blended light may be generated with OLEDs exhibiting a stacked architecture, in particular white light may be generated by stacking blue, green and red OLEDs. Furthermore, the OLED exhibiting a stacked architecture may comprise a charge generation layer (CGL), which is typically located between two OLED subunits and typically consists of a n-doped and p-doped layer with the n-doped layer of one CGL being typically located closer to the anode layer.

In one embodiment of the invention, the optoelectronic device is an OLED, which comprises two or more emission layers between anode and cathode. In particular, this so-called tandem OLED comprises three emission layers, wherein one emission layer emits red light, one emission layer emits green light and one emission layer emits blue light, and optionally may comprise further layers such as charge generation layers, blocking or transporting layers between the individual emission layers. In a further embodiment, the emission layers are adjacently stacked. In a further embodiment, the tandem OLED comprises a charge generation layer between each two emission layers. In addition, adjacent emission layers or emission layers separated by a charge generation layer may be merged.

The substrate may be formed by any material or composition of materials. Most frequently, glass slides are used as substrates. Alternatively, thin metal layers (e.g., copper, gold, silver or aluminum films) or plastic films or slides may be used. This may allow for a higher degree of flexibility. The anode layer A is mostly composed of materials allowing to obtain an (essentially) transparent film. As at least one of both electrodes should be (essentially) transparent in order to allow light emission from the OLED, either the anode layer A or the cathode layer C is transparent. Preferably, the anode layer A comprises a large content or even consists of transparent conductive oxides (TCOs). Such anode layer A may, for

example, comprise indium tin oxide, aluminum zinc oxide, fluorine doped tin oxide, indium zinc oxide, PbO, SnO, zirconium oxide, molybdenum oxide, vanadium oxide, tungsten oxide, graphite, doped Si, doped Ge, doped GaAs, doped polyaniline, doped polypyrrol and/or doped polythiophene.

The anode layer A (essentially) may consist of indium tin oxide (ITO) (e.g., $(InO_3)_{0.9}(SnO_2)_{0.1}$). The roughness of the anode layer A caused by the transparent conductive oxides (TCOs) may be compensated by using a hole injection layer (HIL). Further, the HIL may facilitate the injection of quasi charge carriers (i.e., holes) in that the transport of the quasi charge carriers from the TCO to the hole transport layer (HTL) is facilitated. The hole injection layer (HIL) may comprise poly-3,4-ethylendioxy thiophene (PEDOT), polystyrene sulfonate (PSS), $MoO_2$, $V_2O_5$, CuPC or CuI, in particular a mixture of PEDOT and PSS. The hole injection layer (HIL) may also prevent the diffusion of metals from the anode layer A into the hole transport layer (HTL). The HIL may, for example, comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl) bis(N1-phenyl-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to the anode layer A or hole injection layer (HIL), a hole transport layer (HTL) is typically located. Herein, any hole transport compound may be used. For example, electron-rich heteroaromatic compounds such as triarylamines and/or carbazoles may be used as hole transport compound. The HTL may decrease the energy barrier between the anode layer A and the light-emitting layer EML. The hole transport layer (HTL) may also be an electron blocking layer (EBL). Preferably, hole transport compounds bear comparably high energy levels of their triplet states T1. For example, the hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, the HTL may comprise a p-doped layer, which may be composed of an inorganic or organic dopant in an organic hole-transporting matrix. Transition metal oxides such as vanadium oxide, molybdenum oxide or tungsten oxide may, for example, be used as inorganic dopant. Tetrafluorotetracyanoquinodimethane ($F_4$-TCNQ), copper-pentafluorobenzoate (Cu(I)pFBz) or transition metal complexes may, for example, be used as organic dopant.

The EBL may, for example, comprise mCP (1,3-bis(carbazol-9-yl)benzene), TCTA, 2-TNATA, mCBP (3,3-di(9H-carbazol-9-yl)biphenyl), tris-Pcz, CzSi (9-(4-tert-Butylphenyl)-3,6-bis(triphenylsilyl)-9H-carbazole), and/or DCB (N,N'-dicarbazolyl-1,4-dimethylbenzene).

Adjacent to the hole transport layer (HTL), the light-emitting layer EML is typically located. The light-emitting layer EML comprises at least one light emitting molecule. Particularly, the EML comprises at least one light emitting molecule according to the invention E. In one embodiment, the light-emitting layer comprises only the organic molecules according to the invention. Typically, the EML additionally comprises one or more host materials H. For example, the host material H is selected from CBP (4,4'-Bis-(N-carbazolyl)-biphenyl), mCP, mCBP Sif87 (dibenzo[b,d]thiophen-2-yltriphenylsilane), CzSi, Sif88 (dibenzo[b,d]thiophen-2-yl)diphenylsilane), DPEPO (bis[2-(diphenylphosphino)phenyl] ether oxide), 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole, 9-[3,5-bis(2-dibenzothiophenyl)phenyl]-9H-carbazole, T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine). The host material H typically should be selected to exhibit first triplet (T1) and first singlet (S1) energy levels, which are energetically higher than the first triplet (T1) and first singlet (S1) energy levels of the organic molecule.

In one embodiment of the invention, the EML comprises a so-called mixed-host system with at least one hole-dominant host and one electron-dominant host. In a particular embodiment, the EML comprises exactly one light emitting organic molecule according to the invention and a mixed-host system comprising T2T as electron-dominant host and a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole as hole-dominant host. In a further embodiment the EML comprises 50-80 % by weight, preferably 60-75 % by weight of a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole; 10-45 % by weight, preferably 15-30 % by weight of T2T and 5-40 % by weight, preferably 10-30 % by weight of light emitting molecule according to the invention.

Adjacent to the light-emitting layer EML, an electron transport layer (ETL) may be located. Herein, any electron transporter may be used. Exemplarily, electron-poor compounds such as, e.g., benzimidazoles, pyridines, triazoles,

oxadiazoles (e.g., 1,3,4-oxadiazole), phosphinoxides and sulfone, may be used. An electron transporter may also be a star-shaped heterocycle such as 1,3,5-tri(1-phenyl-1H-benzo[d]imidazol-2-yl)phenyl (TPBi). The ETL may comprise NBphen (2,9-bis(naphthalen-2-yl)-4,7-diphenyl-1,10-phenanthroline), $Alq_3$ (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the ETL may be doped with materials such as Liq. The electron transport layer (ETL) may also block holes or a holeblocking layer (HBL) is introduced.

The HBL may, for example, comprise BCP (2,9-dimethyl-4,7-diphenyl-1,10-phenanthroline = Bathocuproine), BAlq (bis(8-hydroxy-2-methylquinoline)-(4-phenylphenoxy)aluminum), NBphen (2,9-bis(naphthalen-2-yl)-4,7-diphenyl-1,10-phenanthroline), $Alq_3$ (Aluminum-tris(8-hydroxyquinoline)), TSPO1 (diphenyl-4-triphenylsilylphenyl-phosphinoxide), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine), and/or TCB/TCP (1,3,5-tris(N-carbazolyl)benzol/ 1,3,5-tris(carbazol)-9-yl) benzene).

Adjacent to the electron transport layer (ETL), a cathode layer C may be located. The cathode layer C may, for example, comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer may also consist of (essentially) intransparent metals such as Mg, Ca or Al. Alternatively or additionally, the cathode layer C may also comprise graphite and or carbon nanotubes (CNTs). Alternatively, the cathode layer C may also consist of nanoscalic silver wires.

An OLED may further, optionally, comprise a protection layer between the electron transport layer (ETL) and the cathode layer C (which may be designated as electron injection layer (EIL)). This layer may comprise lithium fluoride, cesium fluoride, silver, Liq (8-hydroxyquinolinolatolithium), $Li_2O$, $BaF_2$, MgO and/or NaF.

Optionally, the electron transport layer (ETL) and/or a hole blocking layer (HBL) may also comprise one or more host compounds H.

In order to modify the emission spectrum and/or the absorption spectrum of the light-emitting layer EML further, the light-emitting layer EML may further comprise one or more further emitter molecules F. Such an emitter molecule F may be any emitter molecule known in the art. Preferably such an emitter molecule F is a molecule with a structure differing from the structure of the molecules according to the invention E. The emitter molecule F may optionally be a TADF emitter. Alternatively, the emitter molecule F may optionally be a fluorescent and/or phosphorescent emitter molecule which is able to shift the emission spectrum and/or the absorption spectrum of the light-emitting layer EML. Exemplarily, the triplet and/or singlet excitons may be transferred from the organic emitter molecule according to the invention to the emitter molecule F before relaxing to the ground state S0 by emitting light typically red-shifted in comparison to the light emitted by an organic molecule. Optionally, the emitter molecule F may also provoke two-photon effects (i.e., the absorption of two photons of half the energy of the absorption maximum).

Optionally, an optoelectronic device (e.g., an OLED) may, for example, be an essentially white optoelectronic device. For example, such white optoelectronic device may comprise at least one (deep) blue emitter molecule and one or more emitter molecules emitting green and/or red light. Then, there may also optionally be energy transmittance between two or more molecules as described above.

As used herein, if not defined more specifically in the particular context, the designation of the colors of emitted and/or absorbed light is as follows:

| | |
|---|---|
| violet: | wavelength range of >380-420 nm; |
| deep blue: | wavelength range of >420-480 nm; |
| sky blue: | wavelength range of >480-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

With respect to emitter molecules, such colors refer to the emission maximum. Therefore, for example, a deep blue emitter has an emission maximum in the range of from >420 to 480 nm, a sky blue emitter has an emission maximum in the range of from >480 to 500 nm, a green emitter has an emission maximum in a range of from >500 to 560 nm, a red emitter has an emission maximum in a range of from >620 to 800 nm.

A deep blue emitter may preferably have an emission maximum of below 480 nm, more preferably below 470 nm, even more preferably below 465 nm or even below 460 nm. It will typically be above 420 nm, preferably above 430 nm, more preferably above 440 nm or even above 450 nm.

Accordingly, a further aspect of the present invention relates to an OLED, which exhibits an external quantum

efficiency at 1000 cd/$m^2$ of more than 8 %, more preferably of more than 10 %, more preferably of more than 13 %, even more preferably of more than 15 % or even more than 20 % and/or exhibits an emission maximum between 420 nm and 500 nm, preferably between 430 nm and 490 nm, more preferably between 440 nm and 480 nm, even more preferably between 450 nm and 470 nm and/or exhibits a LT80 value at 500 cd/$m^2$ of more than 100 h, preferably more than 200 h, more preferably more than 400 h, even more preferably more than 750 h or even more than 1000 h. Accordingly, a further aspect of the present invention relates to an OLED, whose emission exhibits a CIEy color coordinate of less than 0.45, preferably less than 0.30, more preferably less than 0.20 or even more preferably less than 0.15 or even less than 0.10.

A further aspect of the present invention relates to an OLED, which emits light at a distinct color point. According to the present invention, the OLED emits light with a narrow emission band (small full width at half maximum (FWHM)). In one aspect, the OLED according to the invention emits light with a FWHM of the main emission peak of less than 0.30 eV, preferably less than 0.25 eV, more preferably less than 0.20 eV, even more preferably less than 0.19 eV or even less than 0.17 eV.

A further aspect of the present invention relates to an OLED, which emits light with CIEx and CIEy color coordinates close to the CIEx (= 0.131) and CIEy (= 0.046) color coordinates of the primary color blue (CIEx = 0.131 and CIEy = 0.046) as defined by ITU-R Recommendation BT.2020 (Rec. 2020) and thus is suited for the use in Ultra High Definition (UHD) displays, e.g. UHD-TVs. Accordingly, a further aspect of the present invention relates to an OLED, whose emission exhibits a CIEx color coordinate of between 0.02 and 0.30, preferably between 0.03 and 0.25, more preferably between 0.05 and 0.20 or even more preferably between 0.08 and 0.18 or even between 0.10 and 0.15 and/ or a CIEy color coordinate of between 0.00 and 0.45, preferably between 0.01 and 0.30, more preferably between 0.02 and 0.20 or even more preferably between 0.03 and 0.15 or even between 0.04 and 0.10.

In a further aspect, the invention relates to a method for producing an optoelectronic component. In this case an organic molecule of the invention is used.

The optoelectronic device, in particular the OLED according to the present invention can be fabricated by any means of vapor deposition and/ or liquid processing. Accordingly, at least one layer is

- prepared by means of a sublimation process,
- prepared by means of an organic vapor phase deposition process,
- prepared by means of a carrier gas sublimation process,
- solution processed or printed.

The methods used to fabricate the optoelectronic device, in particular the OLED according to the present invention are known in the art. The different layers are individually and successively deposited on a suitable substrate by means of subsequent deposition processes. The individual layers may be deposited using the same or differing deposition methods.

Vapor deposition processes, for example, comprise thermal (co)evaporation, chemical vapor deposition and physical vapor deposition. For active matrix OLED display, an AMOLED backplane is used as substrate. The individual layer may be processed from solutions or dispersions employing adequate solvents. Solution deposition process, for example, comprise spin coating, dip coating and jet printing. Liquid processing may optionally be carried out in an inert atmosphere (e.g., in a nitrogen atmosphere) and the solvent may be completely or partially removed by means known in the state of the art.

## Examples

### General synthesis scheme I

General synthesis scheme I provides a synthesis scheme for organic molecules according to the invention wherein $R^X = R^I$, $R^{IX} = R^{II}$, $R^{VIII} = R^1$, $R^{III} = R^1$, $R^{VII} = R^{IV}$, $R^V = R^{VI}$ and $T = R^1$ and $V = V^\#$:

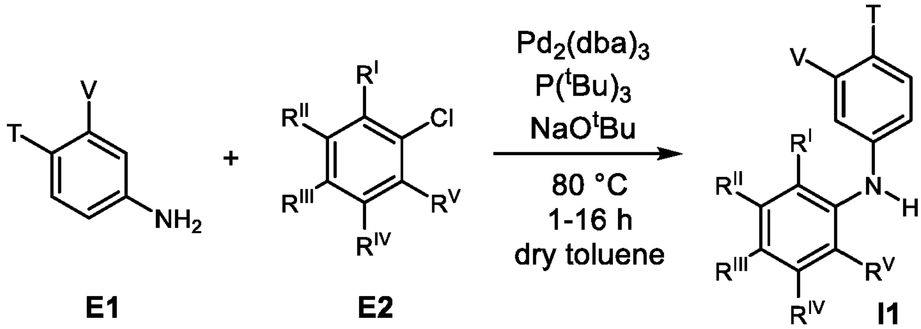


E1 E2 I1

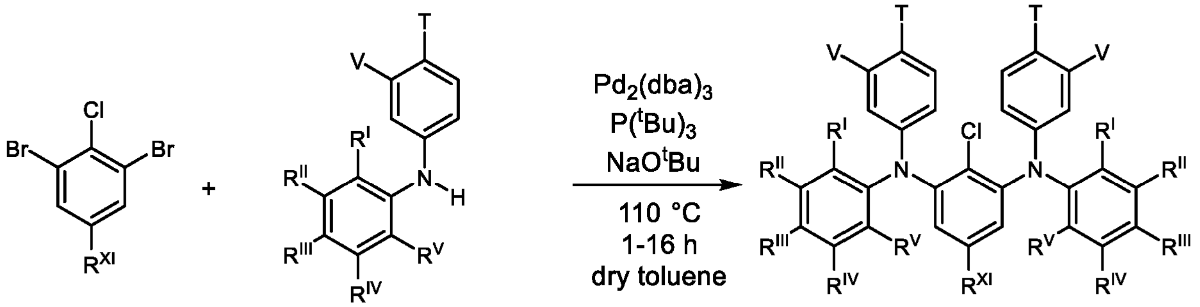


E3 I1 I2

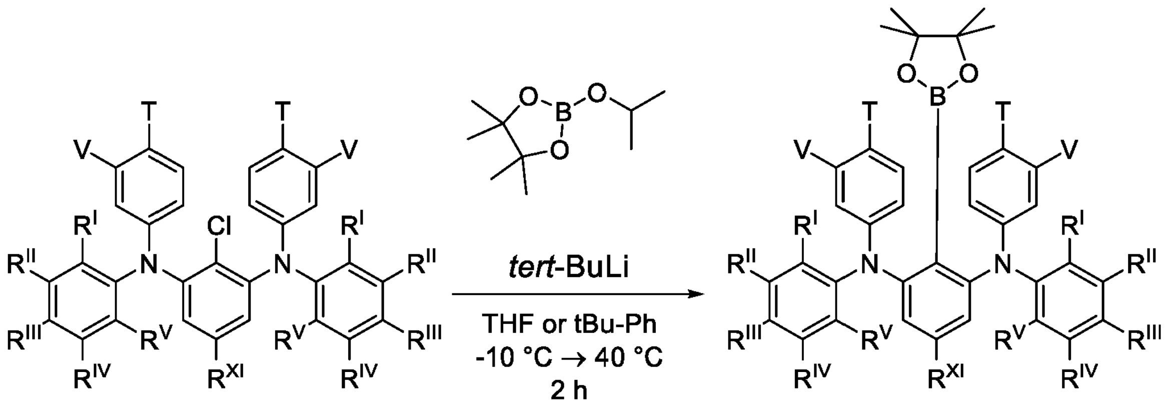


I2 I3

Alternatively, trimethyl borate may be used as borylating reagent yielding the boronic acid derivatives corresponding to **I3**.

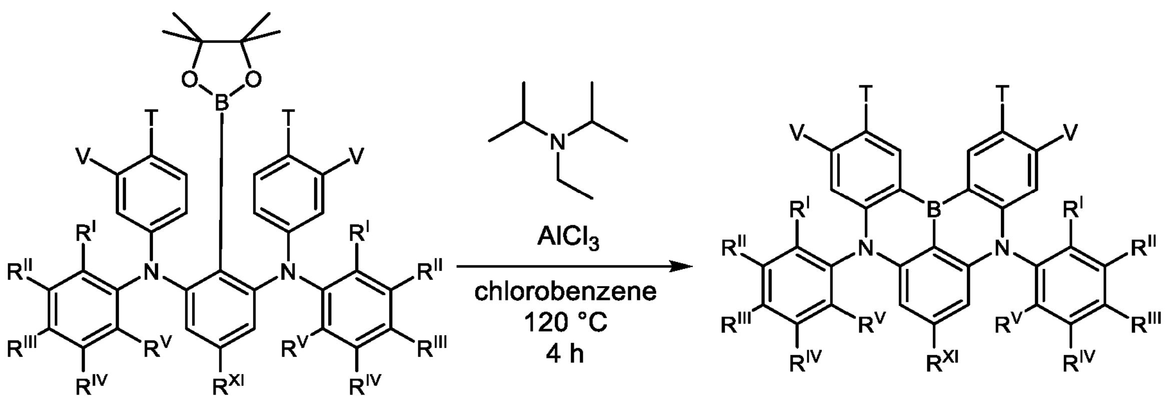


I3 P1

Alternatively, the corresponding boronic acid derivative of substrate **I3** might be used as starting material under

the same conditions.

Alternative one-pot ring closure scheme directly converting **I2** to P1.

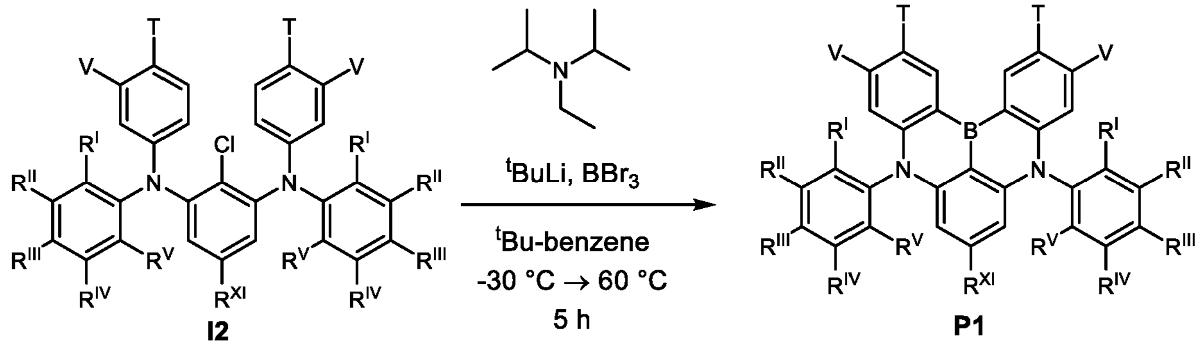


**I2** **P1**

*General procedure for synthesis* ***AAV1*:**

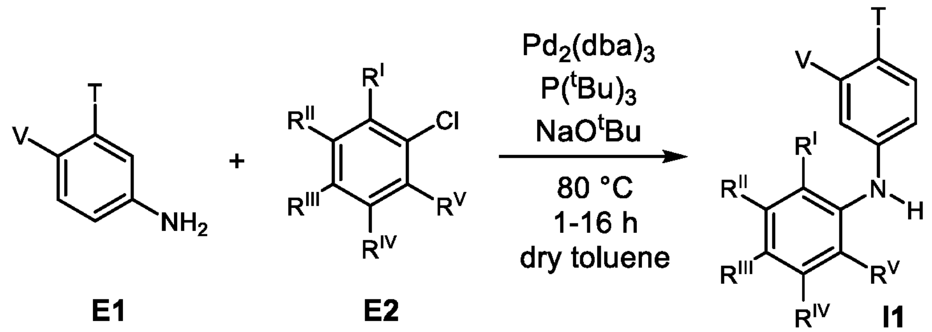


**E1** **E2** **I1**

E1 (1.00 equivalents), E2 (1.10 equivalents), tris(dibenzylideneacetone)dipalladium $Pd_2(dba)_3$ (0.01 equivalents; CAS: 51364-51-3), tri-tert-butyl-phosphine ($P(^tBu)_3$, CAS: 13716-12-6 , 0.04 equivalents) and sodium tert-butoxide ($NaO^tBu$; 1.70 equivalents) are stirred under nitrogen atmosphere in toluene at 80 °C for 1-16 h. After cooling down to room temperature (rt) the reaction mixture is extracted with toluene and water and the phases are separated. The combined organic layers are dried over $MgSO_4$ and then the solvent is removed under reduced pressure. The crude product obtained is purified by recrystallization or column chromatography and 11 is obtained as solid or an oil.

*General procedure for synthesis* ***AAV2*:**

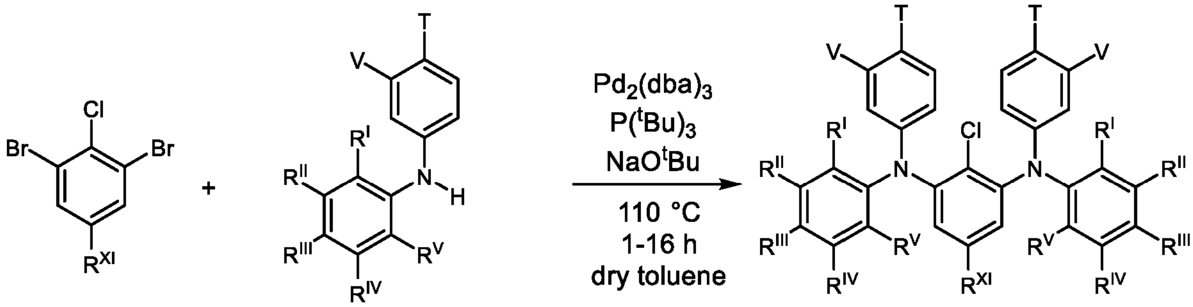


**E3** **I1** **I2**

**11** (2.20 equivalents), **E3** (1.00 equivalents), tris(dibenzylideneacetone)-dipalladium $Pd_2(dba)_3$ (0.02 equivalents; CAS: 51364-51-3), tri-tert-butyl-phosphine (0.08 equivalents, $P(^tBu)_3$, CAS: 13716-12-6) and sodium tert-butoxide ($NaO^tBu$; 3.30 equivalents) are stirred under nitrogen atmosphere in toluene at 110 °C for 1-16 h. After cooling down to room temperature (rt) the reaction mixture is extracted with toluene and water and the phases are separated. The

combined organic layers are dried over $MgSO_4$ and then the solvent is removed under reduced pressure. The crude product obtained is purified by recrystallization or column chromatography and **I2** is obtained as solid.

*General procedure for synthesis **AAV3**:*

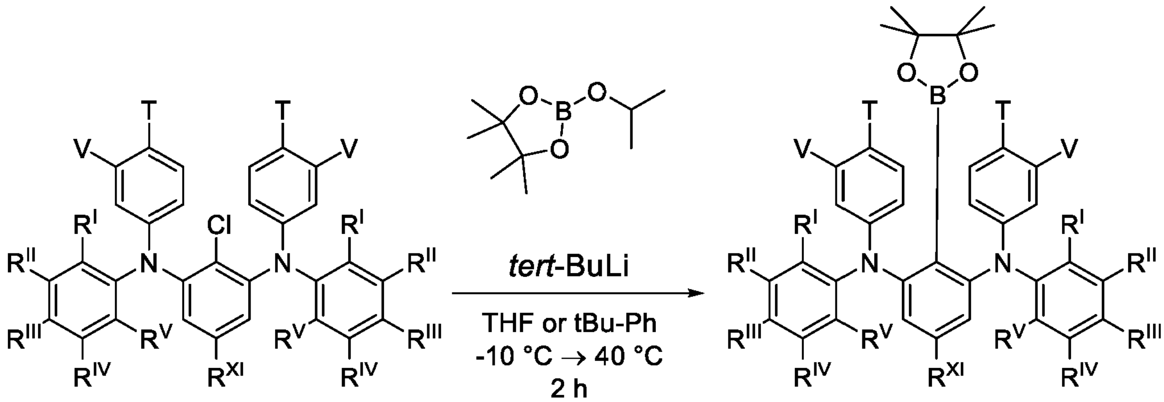


**I2** **I3**

Under nitrogen atmosphere **I2** (1.00 equivalent) is dissolved in dry THF. The resulting solution is cooled down to -10 °C. Subsequently, *tert-BuLi* (2.20 equivalents, CAS: 594-19-4) is slowly added and stirring is continued at 0 °C. After complete lithiation, 1,3,2-dioxaborolane (3.00 equivalents, CAS: 61676-62-8 or alternatively trimethyl borate, CAS 121-43-7) is added, followed by heating at 40 °C for 2 h. After cooling down to room temperature (rt), water is added and the phases separated. The combined organic layers are dried over $MgSO_4$, filtered and concentrated under reduced pressure. The crude product obtained is purified by recrystallization or column chromatography to yield **I3** or the corresponding boronic acid, respectively, as solid.

*General procedure for synthesis **AAV4**:*

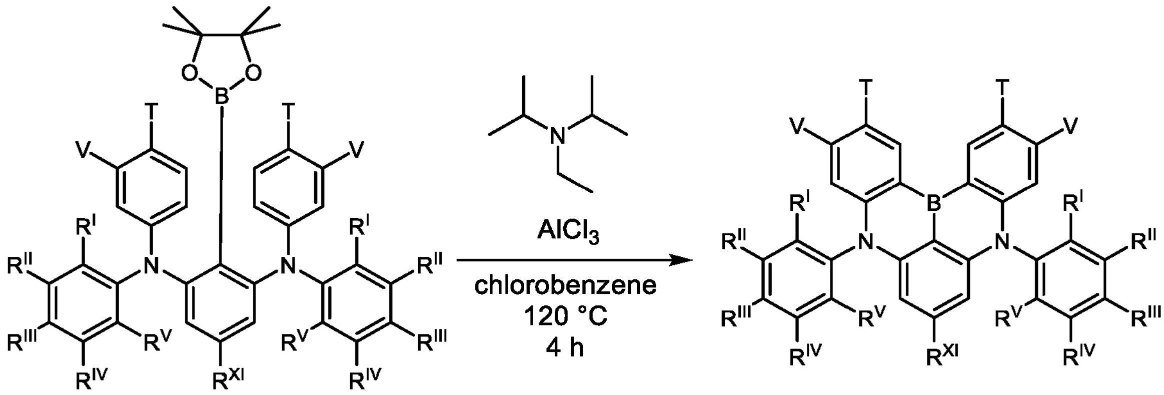


**I3** **P1**

**I3** (1.00 equivalent), N,N-diisopropylethylamine (10 equivalents, CAS: 7087-68-5) and $AlCl_3$ (10 equivalents, CAS: 7446-70-0) are stirred under nitrogen atmosphere in chlorobenzene at 120°C for 4 h. After cooling down to room temperature (rt) the reaction mixture is extracted between toluene and water and the phases are separated. The combined organic layers are dried over $MgSO_4$ and then the solvent is removed under reduced pressure. The crude product obtained is purified by recrystallization or column chromatography and **P1** is obtained as solid.

*General procedure for synthesis **AA V5:***

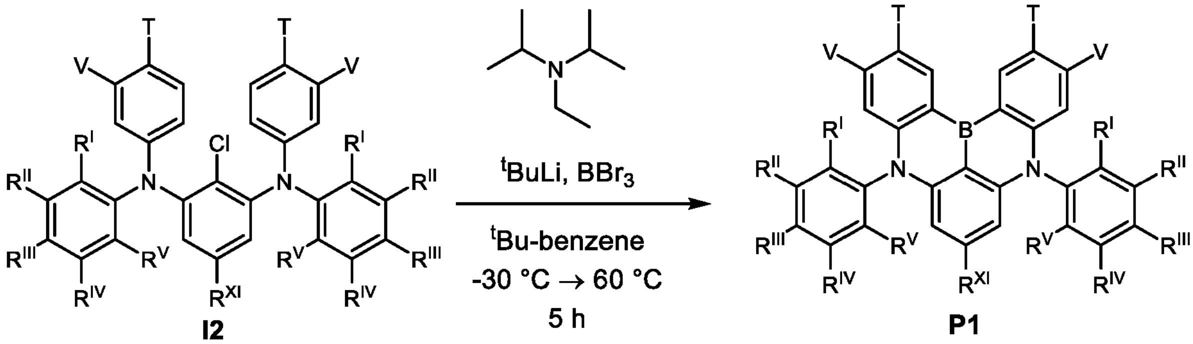


I2 P1

**I2** (1.00 equivalents) is dissolved in tert-butylbenzene under nitrogen atmosphere and the solution is cooled to -30°C. A solution of tert-butyllithium ($^tBuLi$) (2.20 equivalents, CAS: 594-19-4) is added dropwise and the reaction mixture is allowed to warm up to 0 °C. After stirring for 120 minutes at 60°C, the solvent of the $^tBuLi$ -solution and byproducts are removed under reduced pressure and the reaction mixture is cooled again to -30 °C. A solution of boron tribromide ($BBr_3$, CAS: 10294-33-4, 2.20 equivalents) is added dropwise, the cooling bath is removed and the reaction mixture is allowed to warm to room temperature (rt). After stirring for 30 minutes at rt, the reaction mixture is cooled to 0 °C and N,N-diisopropylethylamine (CAS: 7087-68-5, 3.00 equivalents) is added. The reaction mixture is allowed to warm to rt and then heated at reflux at 120 °C for 3h. Subsequently, the reaction mixture is poured into water and the resulting precipitate is filtered and washed with a minimum amount of ethyl acetate to obtain **P1** as a solid product. **P1** can be further purified by recrystallization or by flash chromatography.

**General Synthesis Scheme II**

General synthesis scheme II provides a synthesis scheme for organic molecules according to the invention, wherein $R^X = R^I$, $R^{IX} = R^{II}$, $R^{VIII} = R^1$, $R^{III} = R^1$, $R^{VII} = R^{IV}$, $R^V = R^{VI}$ and $T = R^1$ and $V = V^\#$:

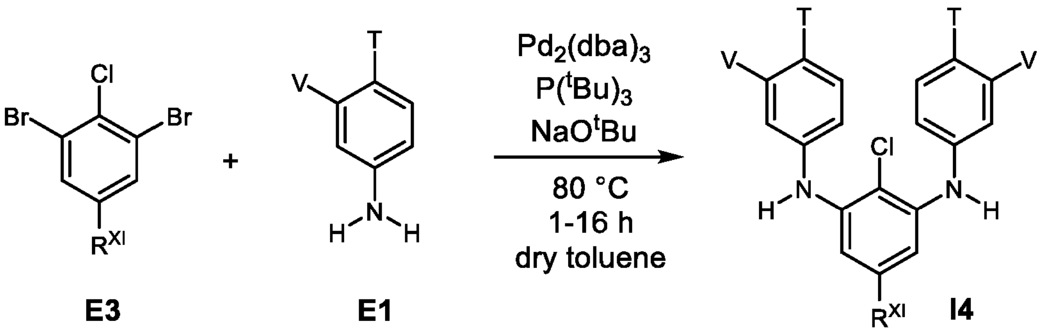


E3 E1 I4

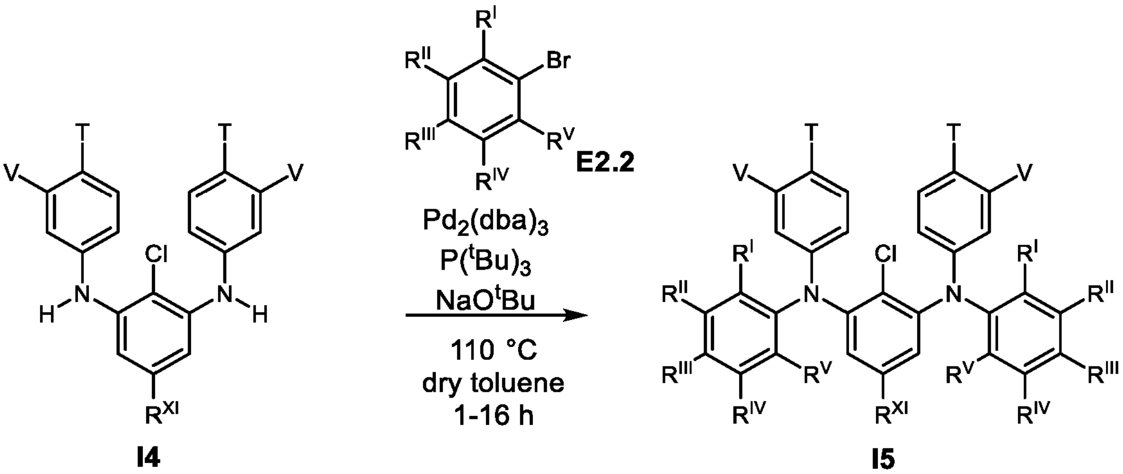


E2.2 I4 I5

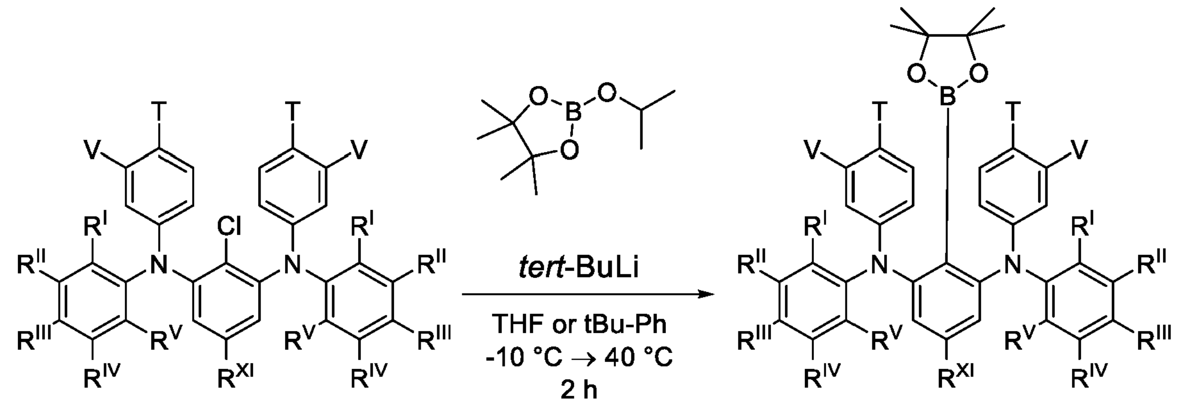


I5 I6

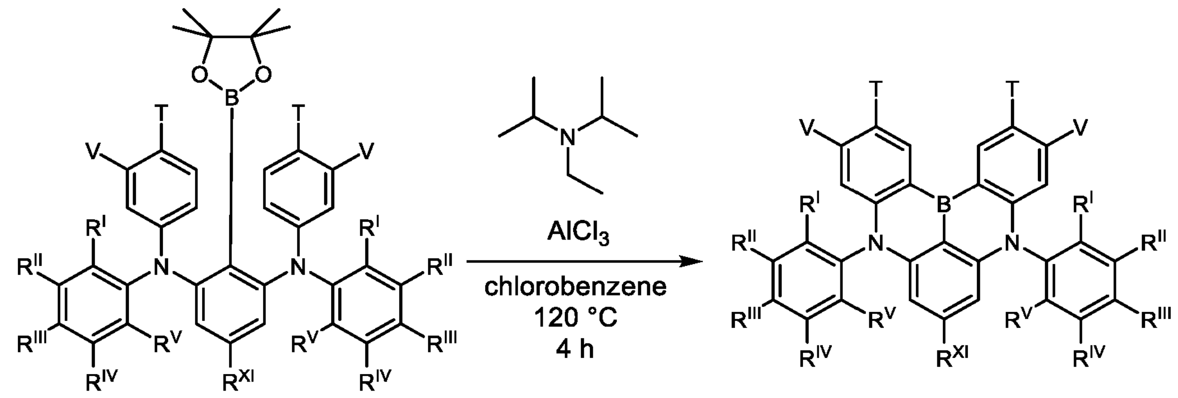


I6 P2

Alternative one-pot procedure to convert **I5** into P2.

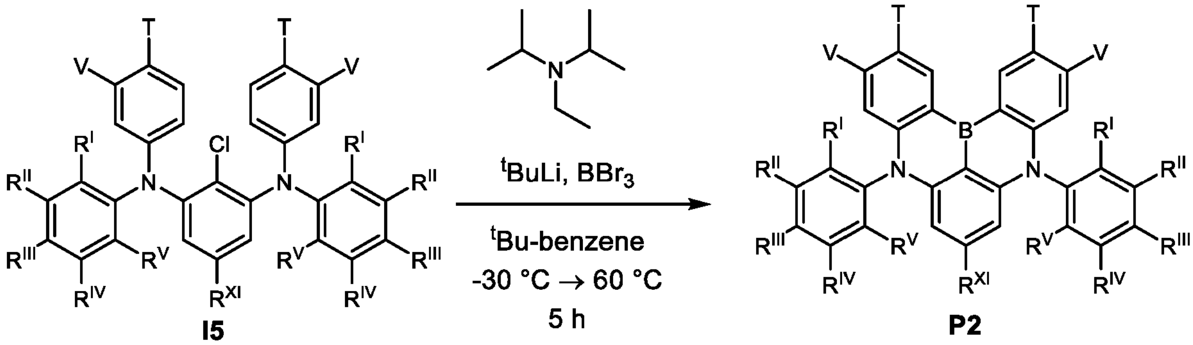


I5 P2

*General procedure for synthesis* ***AAV6***

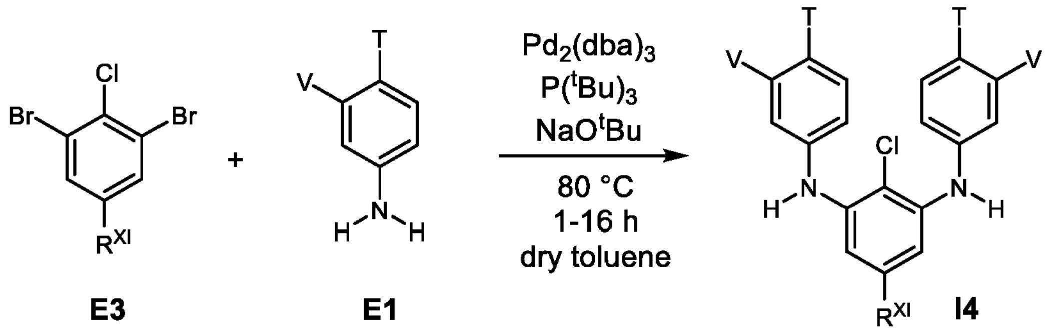


E3 E1 I4

E3 (1.00 equivalents), E1 (2.20 equivalents), tris(dibenzylideneacetone)dipalladium $Pd_2(dba)_3$ (0.01 equivalents; CAS: 51364-51-3), tri-tert-butyl-phosphine ($P(^tBu)_3$, CAS: 13716-12-6 , 0.04 equivalents) and sodium tert-butoxide ($NaO^tBu$; 3.30 equivalents) are stirred under nitrogen atmosphere in toluene at 80 °C for 1-16 h. After cooling down to room temperature (rt) the reaction mixture is extracted with toluene and water and the phases are separated. The combined organic layers are dried over $MgSO_4$ and then the solvent is removed under reduced pressure. The crude product obtained is purified by recrystallization or column chromatography and **I4** is obtained as solid or an oil.

*General procedure for synthesis **AAV7***

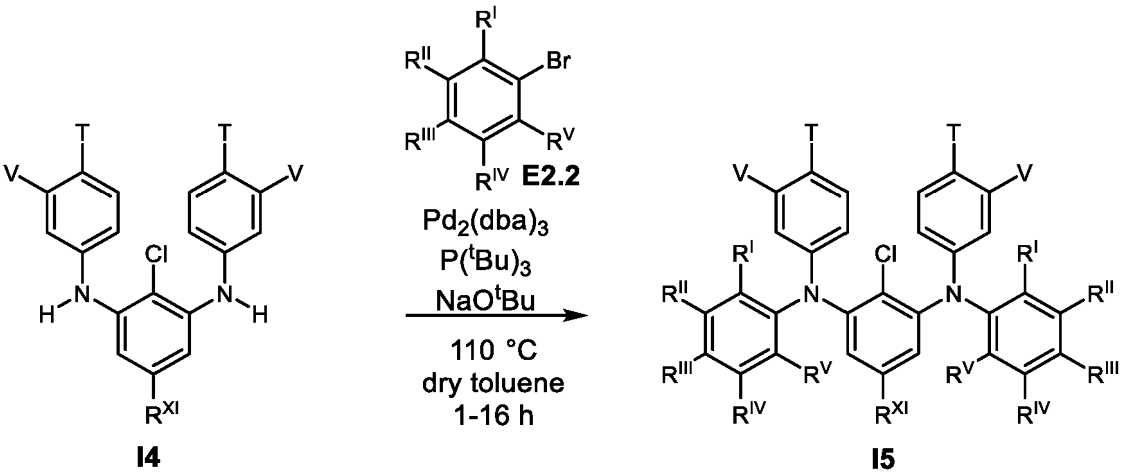


I4 I5

**I4** (1.00 equivalents), **E2.2** (2.20 equivalents), tris(dibenzylideneacetone)-dipalladium $Pd_2(dba)_3$ (0.02 equivalents; CAS: 51364-51-3), tri-tert-butyl-phosphine (0.08 equivalents, $P(^tBu)_3$, CAS: 13716-12-6) and sodium tert-butoxide ($NaO^tBu$; 3.30 equivalents) are stirred under nitrogen atmosphere in toluene at 110 °C for 1-16 h. After cooling down to room temperature (rt) the reaction mixture is extracted with toluene and water and the phases are separated. The combined organic layers are dried over $MgSO_4$ and then the solvent is removed under reduced pressure. The crude product obtained is purified by recrystallization or column chromatography and **I5** is obtained as solid.

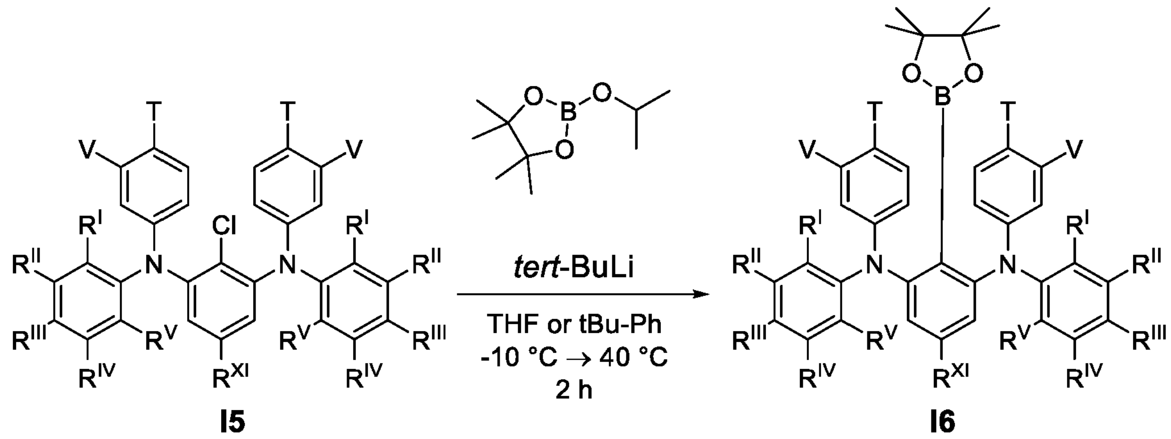


Boronic acid ester **I6** is obtained according to ***AAV3*** using compound **I5** as the starting material. Alternatively, trimethyl borate may be used as borylating reagent yielding the boronic acid derivatives corresponding to **I6.**

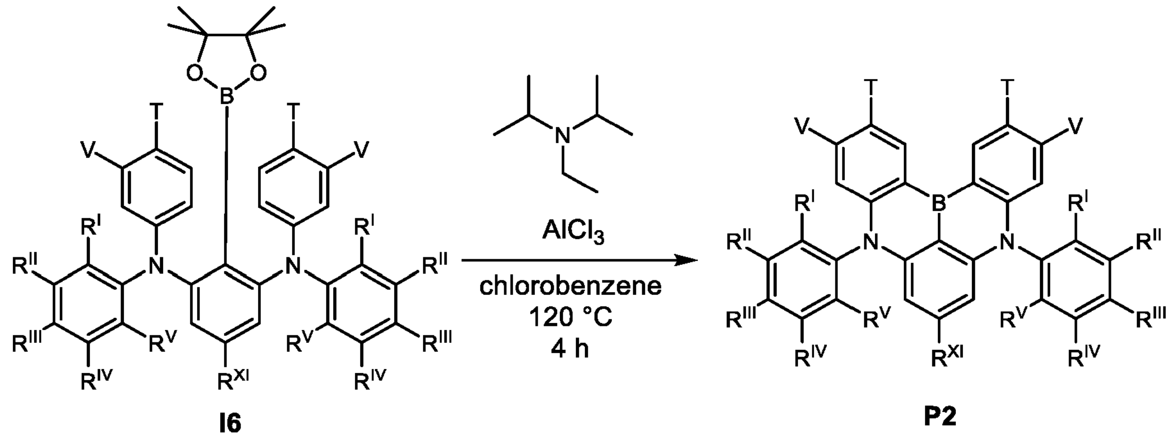


Target compound **P2** is synthesized according to ***AAV4*** using boronic acid ester **I6** as the starting material. Alternatively, the boronic acid corresponding to **I6** can be used as the starting material for the synthesis of P2.

Alternative one-pot procedure to convert **I5** into P2.

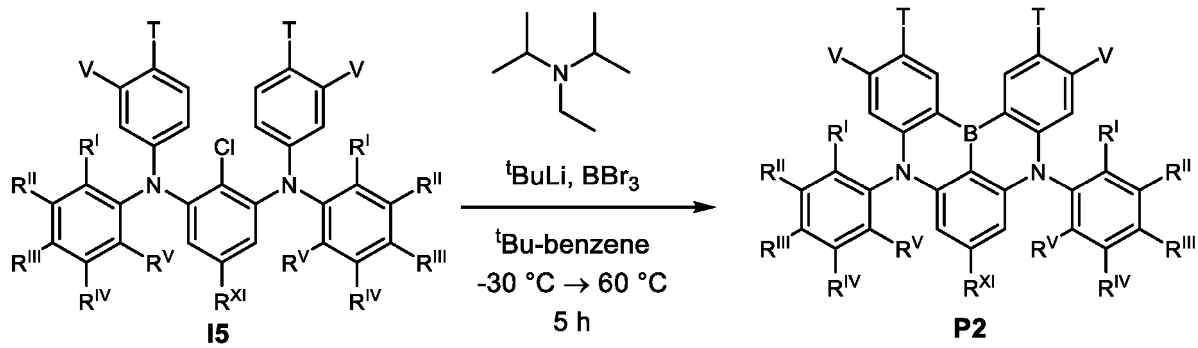


The synthesis of the target **P2** is conducted via a one-pot protocol, where the chloride precursor **I5** is directly converted into **P2** following the procedure described within ***AAV5.***

**General Synthesis Scheme III**

General synthesis scheme IV provides a synthesis scheme for organic molecules according to the invention, wherein $R^X = R^I$, $R^{IX} = R^{II}$, $R^{VIII} = R^1$, $R^{III} = R^1$, $R^{VII} = R^{IV}$, $R^V = R^{VI}$ and $T = R^1$ and $V = V^\#$:

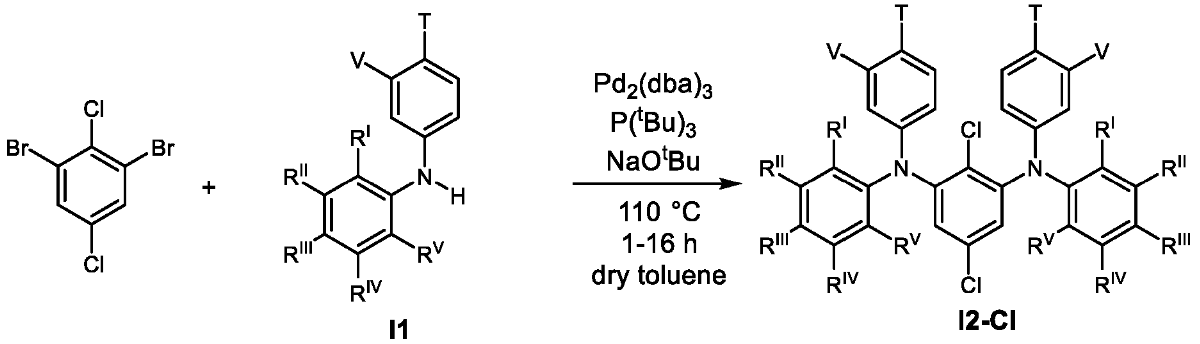


I1

I2-Cl

The synthesis of dichloro derivative **I2-Cl** is performed as described within **AAV2,** starting from 1,3-Dibromo-2,5-dichlorobenzene (1.0 equivalents, CAS: 81067-41-6) and amine **I2.**

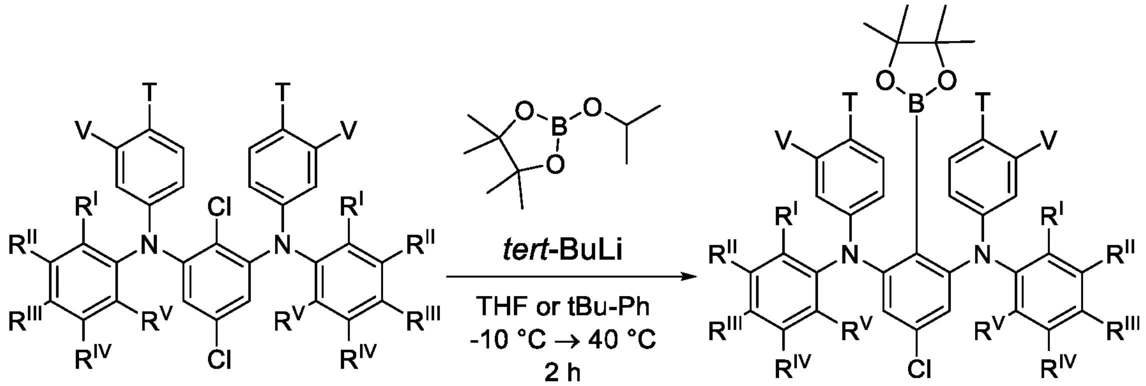


I2-Cl

I3-Cl

Boronic ester **I3-Cl** is synthesized from **I2-Cl** following the procedure of ***AAV3,*** wherein alternatively, trimethyl borate may be used as borylating reagent yielding the boronic acid derivatives corresponding to **I3-Cl.**

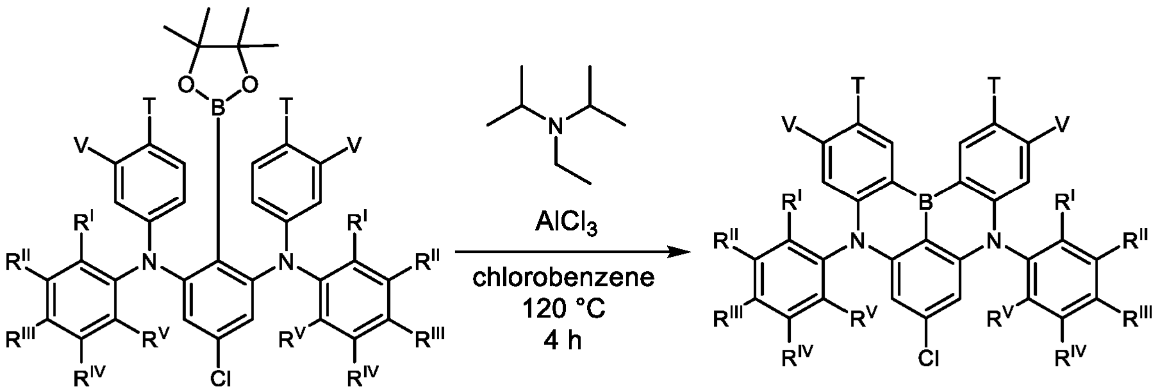


I3-Cl

P1-Cl

The para-chloro derivative **P1-Cl** is synthesized from **P1-Cl** as described within ***AAV4.*** Alternatively, under the same conditions, the corresponding boronic acid derivative of substrate **I3-Cl** might be used as starting material yielding **P1-Cl.**

Alternative one-pot ring closure scheme directly converting **I2-Cl** to **P1-Cl.**

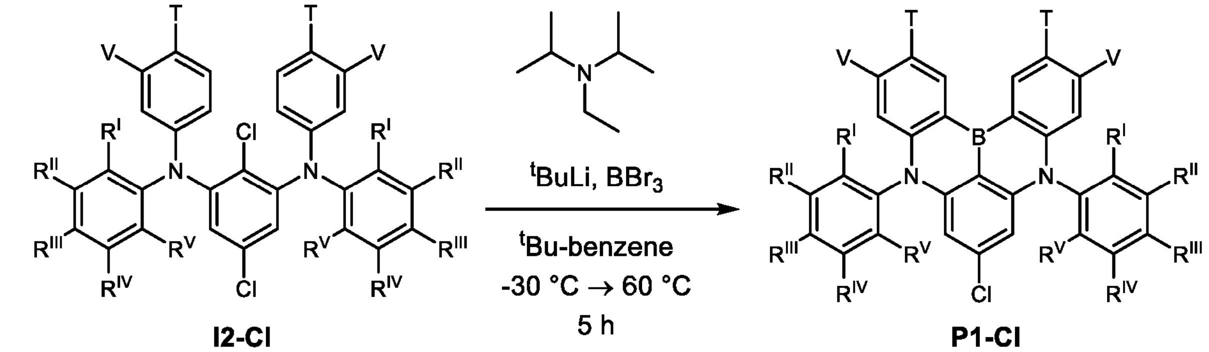


I2-Cl P1-Cl

The one-pot synthesis of **P1-Cl** starting from **I2-Cl** is carried out as described within AAV5.

*General procedure for synthesis **AAV10**:*

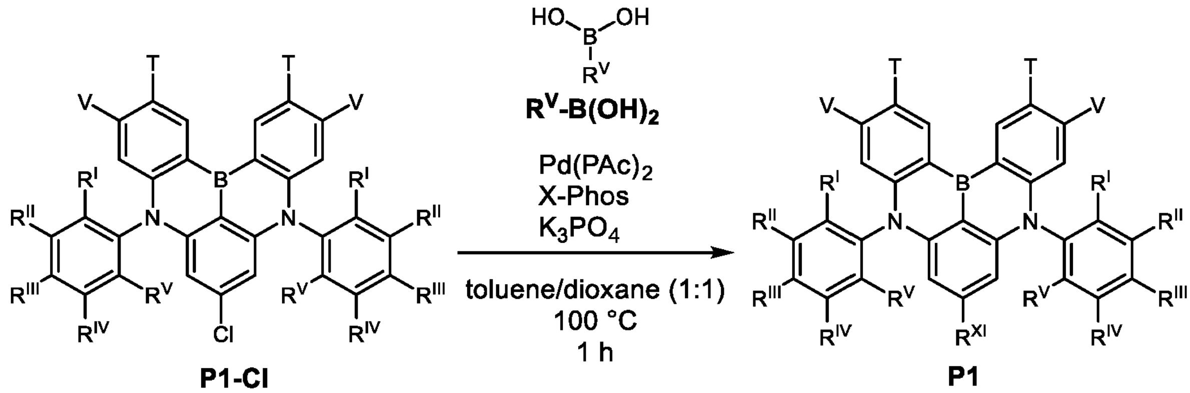


P1-Cl P1

Under nitrogen atmosphere compound **P1-Cl** (1.0 equivalent), boronic acid **$R^V$-B(OH)$_2$** (6.0 equivalents), Palladium-(II)-acetate (0.06 equivalents, CAS: 3375-31-3), X-Phos (0.24 equivalents, CAS: 564483-18-7) and tribasic potassium phosphate (9.0 equivalents, CAS: 7778-53-2) are stirred in a mixture of toluene and dioxane (1:1) at 100 °C for 1 h. After cooling down to room temperature (rt) the reaction mixture is extracted with toluene and water and the phases are separated. The combined organic layers are treated with activated charcoal for 10 min, followed by filtration through a pad of Celite® (kieselgur). The filtrate is dried over $MgSO_4$ and then the solvent is removed under reduced pressure. The crude product obtained is purified by recrystallization or column chromatography and P1 is obtained as solid.

**General Synthesis Scheme IV**

General synthesis scheme IV provides a synthesis scheme for organic molecules according to the invention, wherein $R^X = R^I$, $R^{IX} = R^{II}$, $R^{VIII} = R^1$, $R^{III} = R^1$, $R^{VII} = R^{IV}$, $R^V = R^{VI}$ and $T = R^1$ and $V = V^\#$:

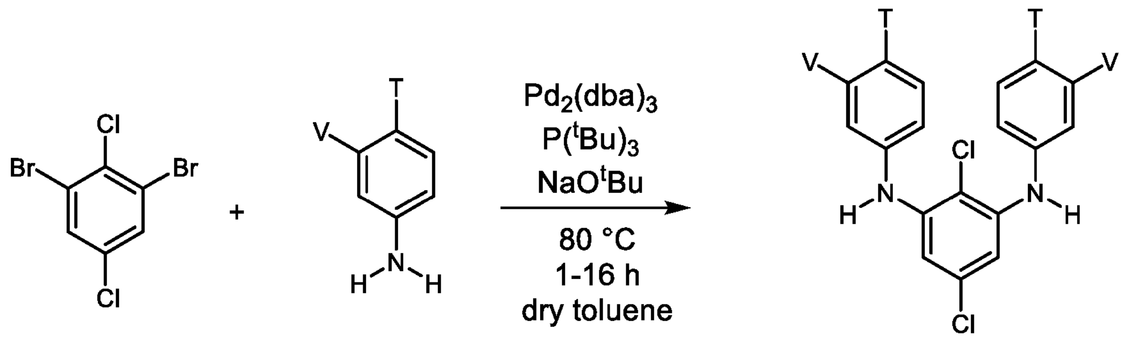


E1 I4-Cl

Compound **I4-Cl** was synthesized accordingly to procedure ***AAV6*** where 1,3-dibromo-2,5-dichlorobenzene (1.0 equivalent, CAS 81067-41-6) and primary amine **E1** were used as the reactants.

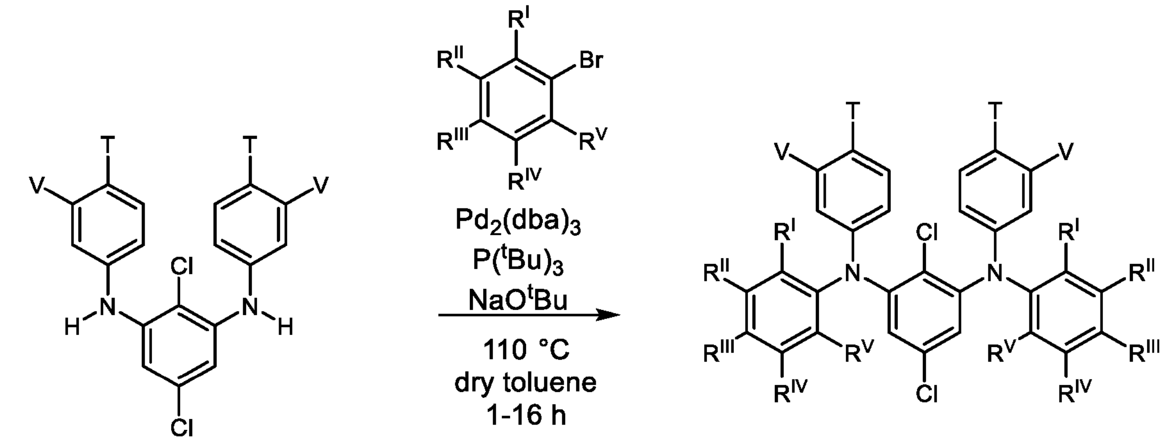


**I4-Cl** **I5-Cl**

Compound **15-Cl** is obtained by following the procedure ***AAV7*** using secondary bisamine **I4-Cl** and 1-bromo-3,5-diphenylbenzene (CAS: 103068-20-8) as the reactants.

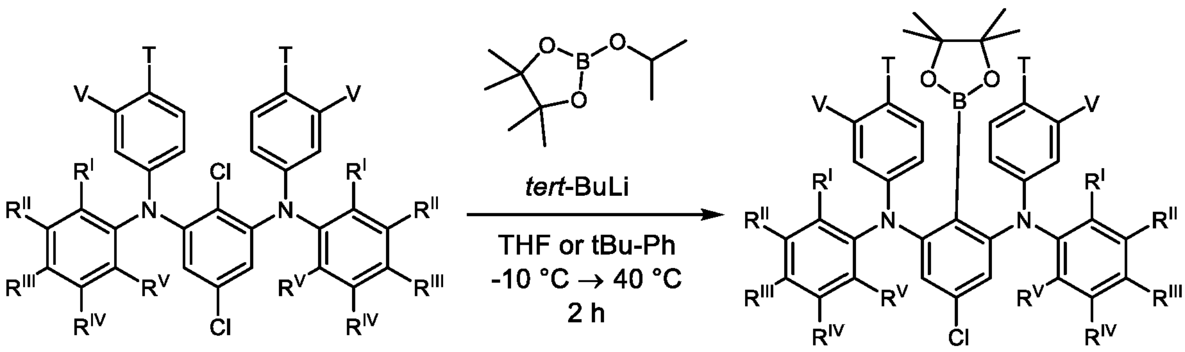


**I5-Cl** **I6-Cl**

Boronic acid ester **I6-Cl** is obtained according to ***AAV3*** using compound **I5-Cl** as the starting material. Alternatively, under the same conditions, trimethyl borate may be used as borylating reagent yielding the boronic acid derivatives corresponding to **I6-Cl.**

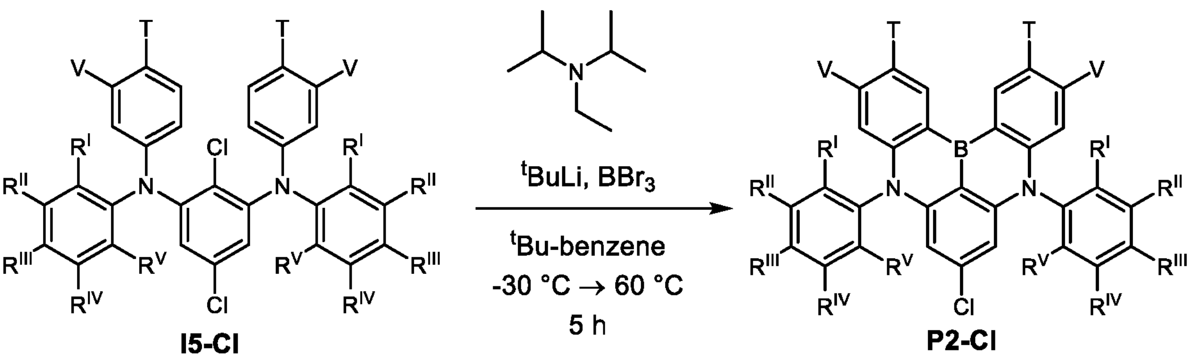


**I5-Cl** **P2-Cl**

The synthesis of **P2-Cl** is conducted as described in ***AAV5*** using **I5-Cl** as the substrate.

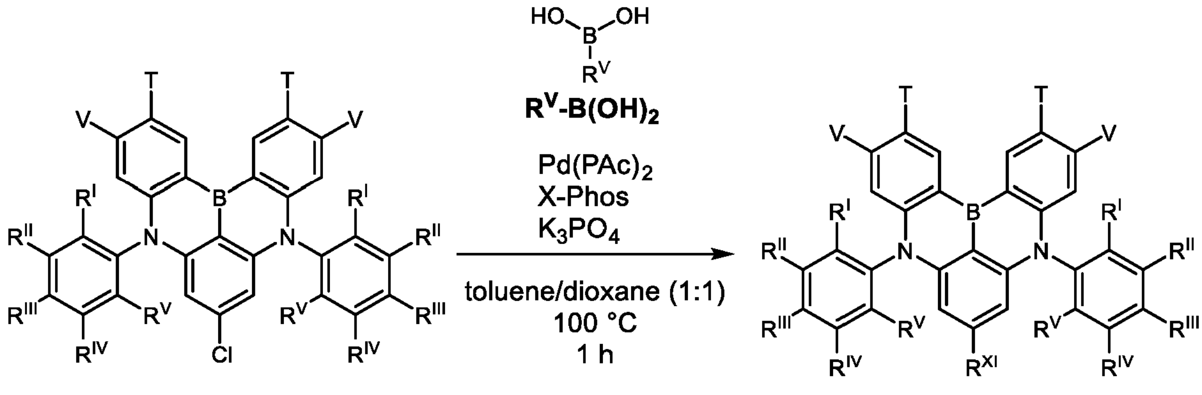


**P2-Cl** **P2**

The target material P2 is synthesized as described in *AAV10* using **P2-Cl** as the starting material.

*Cyclic voltammetry*

Cyclic voltammograms are measured from solutions having concentration of $10^{-3}$ mol/L of the organic molecules in dichloromethane or a suitable solvent and a suitable supporting electrolyte (e.g. 0.1 mol/L of tetrabutylammonium hexafluorophosphate). The measurements are conducted at room temperature under nitrogen atmosphere with a three-electrode assembly (Working and counter electrodes: Pt wire, reference electrode: Pt wire) and calibrated using $FeCp_2/FeCp_2^+$ as internal standard. The HOMO data was corrected using ferrocene as internal standard against a saturated calomel electrode (SCE).

*Density functional theory calculation*

Molecular structures are optimized employing the BP86 functional and the resolution of identity approach (RI). Excitation energies are calculated using the (BP86) optimized structures employing Time-Dependent DFT (TD-DFT) methods. Orbital and excited state energies are calculated with the B3LYP functional. Def2-SVP basis sets (and a m4-grid for numerical integration are used. The Turbomole program package is used for all calculations.

*Photophysical measurements*

Sample pretreatment: Spin-coating
Apparatus: Spin150, SPS euro.

The sample concentration is 10 mg/ml, dissolved in a suitable solvent.

Program: 1) 3 s at 400 U/min; 20 s at 1000 U/min at 1000 Upm/s. 3) 10 s at 4000 U/min at 1000 Upm/s. After coating, the films are dried at 70 °C for 1 min.

Photoluminescence spectroscopy and Time-Correlated Single-Photon Counting (TCSPC) Steady-state emission spectroscopy is measured by a Horiba Scientific, Modell FluoroMax-4 equipped with a 150 W Xenon-Arc lamp, excitation- and emissions monochromators and a Hamamatsu R928 photomultiplier and a time-correlated single-photon counting option. Emissions and excitation spectra are corrected using standard correction fits.

Excited state lifetimes are determined employing the same system using the TCSPC method with FM-2013 equipment and a Horiba Yvon TCSPC hub.

Excitation sources:

NanoLED 370 (wavelength: 371 nm, puls duration: 1,1 ns)
NanoLED 290 (wavelength: 294 nm, puls duration: <1 ns)
SpectraLED 310 (wavelength: 314 nm)
SpectraLED 355 (wavelength: 355 nm).

Data analysis (exponential fit) is done using the software suite DataStation and DAS6 analysis software. The fit is specified using the chi-squared-test.

Photoluminescence quantum yield measurements

For photoluminescence quantum yield (PLQY) measurements an *Absolute PL Quantum Yield Measurement C9920-03G* system *(Hamamatsu Photonics)* is used. Quantum yields and CIE coordinates are determined using the software U6039-05 version 3.6.0.
Emission maxima are given in nm, quantum yields Φ in % and CIE coordinates as x,y values. PLQY is determined using the following protocol:

1) Quality assurance: Anthracene in ethanol (known concentration) is used as reference
2) Excitation wavelength: the absorption maximum of the organic molecule is determined and the molecule is excited using this wavelength
3) Measurement
Quantum yields are measured, for sample, of solutions or films under nitrogen atmosphere. The yield is calculated using the equation:

$$\Phi_{PL} = \frac{n_{photon}, emited}{n_{photon}, absorbed} = \frac{\int \frac{\lambda}{hc}\left[Int_{emitted}^{sample}(\lambda) - Int_{absorbed}^{sample}(\lambda)\right]d\lambda}{\int \frac{\lambda}{hc}\left[Int_{emitted}^{reference}(\lambda) - Int_{absorbed}^{reference}(\lambda)\right]d\lambda}$$

wherein $n_{photon}$ denotes the photon count and Int. the intensity.

**Production and characterization of optoelectronic** devices

Optoelectronic devices, in particular OLED devices, comprising organic molecules according to the invention can be produced via vacuum-deposition methods. If a layer contains more than one compound, the weight-percentage of one or more compounds is given in %. The total weight-percentage values amount to 100 %, thus if a value is not given, the fraction of this compound equals to the difference between the given values and 100 %.
The not fully optimized OLEDs are characterized using standard methods and measuring electroluminescence spectra, the external quantum efficiency (in %) in dependency on the intensity, calculated using the light detected by the photodiode, and the current. The OLED device lifetime is extracted from the change of the luminance during operation at constant current density. The LT50 value corresponds to the time, where the measured luminance decreased to 50 % of the initial luminance, analogously LT80 corresponds to the time point, at which the measured luminance decreased to 80 % of the initial luminance, LT 95 to the time point, at which the measured luminance decreased to 95 % of the initial luminance etc.
Accelerated lifetime measurements are performed (e.g. applying increased current densities). For example, LT80 values at 500 cd/m$^2$ are determined using the following equation:

$$\text{LT80}\left(500\frac{cd^2}{m^2}\right) = \text{LT80}(L_0)\left(\frac{L_0}{500\frac{cd^2}{m^2}}\right)^{1.6}$$

wherein $L_0$ denotes the initial luminance at the applied current density.
The values correspond to the average of several pixels (typically two to eight), the standard deviation between these pixels is given.

**HPLC-MS**

HPLC-MS analysis is performed on an HPLC by Agilent (1100 series) with MS-detector (Thermo LTQ XL).
Exemplarly a typical HPLC method is as follows: a reverse phase column 4,6mm x 150mm, particle size 3,5 µm from Agilent *(ZORBAX Eclipse Plus 95Å C18*, 4.6 x *150 mm, 3.5 µm HPLC column)* is used in the HPLC. The HPLC-MS measurements are performed at room temperature (rt) following gradients

| Flow rate [ml/min] | Time [min] | A[%] | B[%] | C[%] |
|---|---|---|---|---|
| 2.5 | 0 | 40 | 50 | 10 |
| 2.5 | 5 | 40 | 50 | 10 |
| 2.5 | 25 | 10 | 20 | 70 |
| 2.5 | 35 | 10 | 20 | 70 |
| 2.5 | 35.01 | 40 | 50 | 10 |
| 2.5 | 40.01 | 40 | 50 | 10 |
| 2.5 | 41.01 | 40 | 50 | 10 |

using the following solvent mixtures:

| | | |
|---|---|---|
| Solvent A: | $H_2O$ (90%) | MeCN (10%) |
| Solvent B: | $H_2O$ (10%) | MeCN (90%) |
| Solvent C: | THF (50%) | MeCN (50%) |

An injection volume of 5 μL from a solution with a concentration of 0.5 mg/mL of the analyte is taken for the measurements.

Ionization of the probe is performed using an atmospheric pressure chemical ionization (APCI) source either in positive (APCI +) or negative (APCI -) ionization mode.

**Example 1**

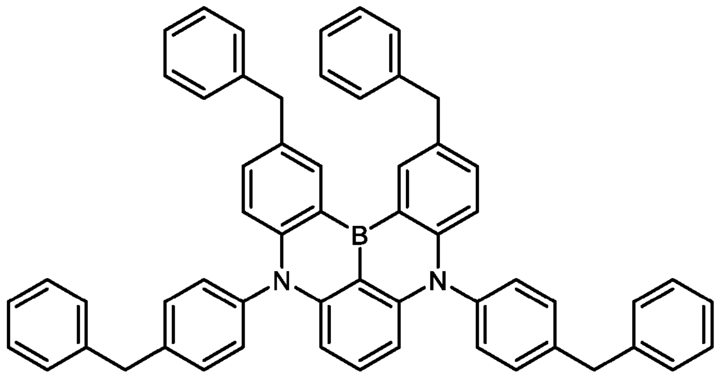

Example 1 was synthesized according to

***AAV1*** (49% yield), wherein 4-chlorodiphenylmethane (CAS 831-81-2) was used as reactant **E2** and 4-benzylaniline (CAS 1135-12-2) as **E1;**
***AAV2*** (42% yield), wherein 1,3-dibromo-2-chlorobenzene (CAS 19230-27-4) was used as reactant E3;
and ***AAV5*** (48% yield).

MS (HPLC-MS, APCI, pos. ionization), m/z (retention time): 781.6 (6.16 min).

The emission maximum of example 1 (2% by weight in PMMA) is at 464 nm, the full width at half maximum (FWHM) is 0.17 eV, the CIEy coordinate is 0.12 and the PLQY is 73%. The onset of the emission spectrum is determined at 2.79 eV.

**Example 2**

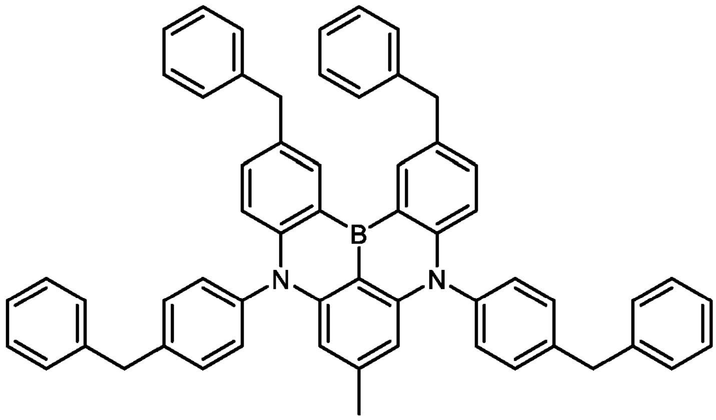

Example 2 was synthesized according to

***AAV1*** (49% yield), wherein 4-chlorodiphenylmethane (CAS 831-81-2) was used as reactant E2 and 4-benzylaniline (CAS 1135-12-2) as E1;
***AAV2*** (69% yield), wherein 4-chloro-3,5-dibromotoluene (CAS 202925-05-1) was used as reactant E3;
and ***AAV5*** (13% yield).

MS (HPLC-MS, APPI, pos. ionization), m/z (retention time): 795.6 (6.26 min).
The emission maximum of example 2 (2% by weight in PMMA) is at 462 nm, the full width at half maximum (FWHM) is 0.17 eV, the CIEy coordinate is 0.11 and the PLQY is 76%. The onset of the emission spectrum is determined at 2.79 eV.

**Example** 3

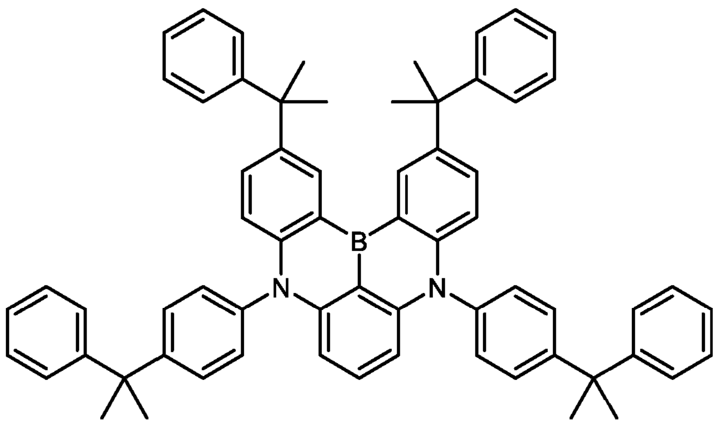

Example 1 was synthesized according to

***AAV2*** (83% yield), wherein 1,3-Dibromo-2-chlorobenzene (CAS 19230-27-4) and 4,4'-bis(alpha,alpha-dimethylbenzyl)diphenylamine (CAS 10081-67-1) were used as reactants E3 and **11,** respectively;
***AAV3*** (32% yield), wherein trimethyl borate (CAS 121-43-7) was used as the borylating reagent and wherein the corresponding boronic acid derivative of **I3** was obtained;
and ***AAV4*** (23% yield).

MS (HPLC-MS, APPI, pos. ionization), m/z (retention time): 893.7 (7.66 min).
The emission maximum of example 3 (2% by weight in PMMA) is at 462 nm, the full width at half maximum (FWHM) is 0.16 eV, the CIEy coordinate is 0.10 and the PLQY is 80%. The onset of the emission spectrum is determined at 2.79 eV.

**Example 4**

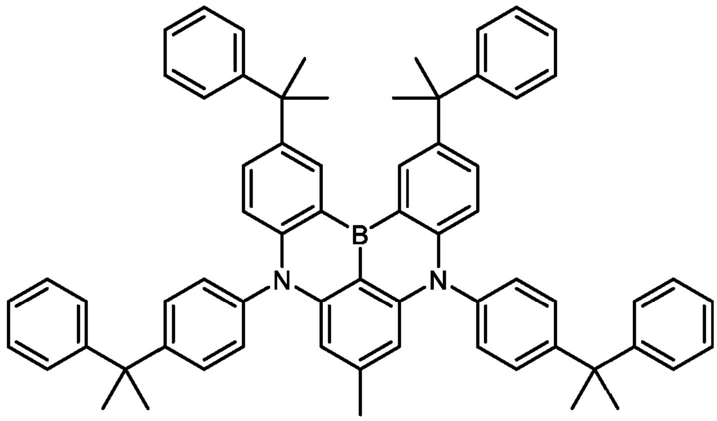

Example **4** was synthesized according to

***AAV2*** (72% yield), wherein 4-Chloro-3,5-dibromotoluene (CAS 202925-05-1) and 4,4'-bis(alpha,alpha-dimethylbenzyl)diphenylamine (CAS 10081-67-1) were used as reactants **E3** and **11,** respectively;
***AAV3*** (50% yield), wherein trimethyl borate (CAS 121-43-7) was used as the borylating reagent and wherein the corresponding dichloride **I2-Cl** was used as the reactant and wherein the corresponding boronic acid derivative of **I3-Cl** was obtained;
***AAV4*** (58% yield);
and ***AAV10*** (81% yield), wherein the corresponding starting material **P1-Cl** was reacted with methaneboronic acid (CAS: 13061-96-6).

MS (HPLC-MS), m/z (retention time): 907.80 (7.68 min).
The emission maximum of example **4** (2% by weight in PMMA) is at 461 nm, the full width at half maximum (FWHM) is 0.17 eV, the CIEy coordinate is 0.10 and the PLQY is 81%. The onset of the emission spectrum is determined at 2.81 eV.

Example **D1**

Example **1** was tested in the OLED **D1,** which was fabricated with the following layer structure:

| **Layer #** | **Thickness** | **D1** |
|---|---|---|
| **9** | 100 nm | Al |
| **8** | 2 nm | Liq |
| **7** | 11 nm | NBPhen |
| **6** | 20 nm | MAT1 |
| **5** | 20 nm | MAT2 (98%) : Example 1 (2%) |
| **4** | 10 nm | MAT3 |
| **3** | 50 nm | MAT4 |
| **2** | 7 nm | HAT-CN |
| **1** | 50 nm | ITO |
| **Substrate** | | Glass |

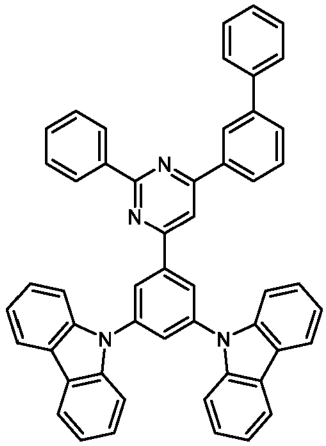

MAT1

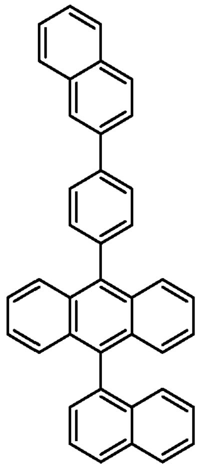

MAT2

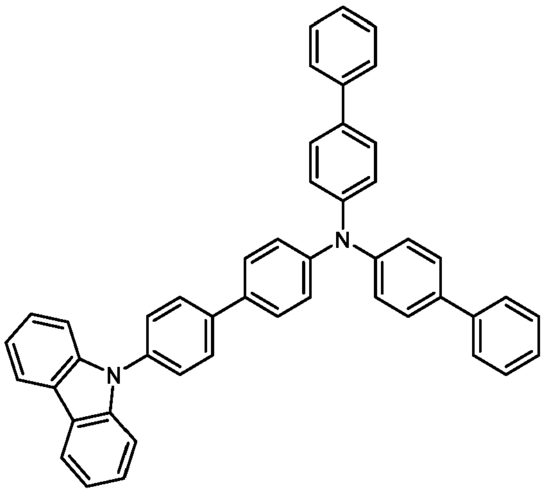

MAT3

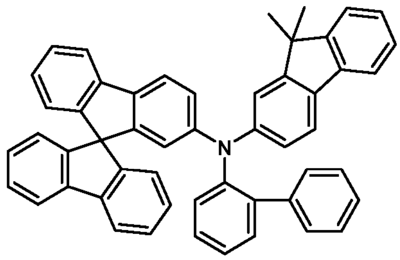

MAT4

OLED **D1** yielded an external quantum efficiency (EQE) at 1000 cd/m$^2$ of 12.1%. The emission maximum is at 468 nm with a FWHM of 26 nm at 3.6 V. The corresponding CIEy value is 0.12.

Example **D2**

Example **2** was tested in the OLED **D2,** which was fabricated with the following layer structure:

| **Layer #** | **Thickness** | **D2** |
|---|---|---|
| **9** | 100 nm | Al |
| **8** | 2 nm | Liq |
| **7** | 11 nm | NBPhen |
| **6** | 20 nm | MAT1 |
| **5** | 20 nm | MAT2 (98%) : Example 2 (2%) |
| **4** | 10 nm | MAT3 |
| **3** | 50 nm | MAT4 |
| **2** | 7 nm | HAT-CN |
| **1** | 50 nm | ITO |

(continued)

| Layer # | Thickness | D2 |
|---|---|---|
| **Substrate** | | Glass |

OLED D2 yielded an external quantum efficiency (EQE) at 1000 cd/$m^2$ of 10.9%. The emission maximum is at 464 nm with a FWHM of 28 nm at 3.8 V. The corresponding CIEy value is 0.10.

Example **D3**

Example **3** was tested in the OLED D3, which was fabricated with the following layer structure:

| Layer # | Thickness | D3 |
|---|---|---|
| **9** | 100 nm | Al |
| **8** | 2 nm | Liq |
| **7** | 11 nm | NBPhen |
| **6** | 20 nm | MAT1 |
| **5** | 20 nm | MAT2 (98%) : Example 3 (2%) |
| **4** | 10 nm | MAT3 |
| **3** | 50 nm | MAT4 |
| **2** | 7 nm | HAT-CN |
| **1** | 50 nm | ITO |
| **Substrate** | | Glass |

OLED **D3** yielded an external quantum efficiency (EQE) at 1000 cd/$m^2$ of 11.8%. The emission maximum is at 466 nm with a FWHM of 26 nm at 3.5 V. The corresponding CIEy value is 0.10.

Example **D4**

Example **4** was tested in the OLED **D4,** which was fabricated with the following layer structure:

| Layer # | Thickness | D4 |
|---|---|---|
| **9** | 100 nm | Al |
| **8** | 2 nm | Liq |
| **7** | 11 nm | NBPhen |
| **6** | 20 nm | MAT1 |
| **5** | 20 nm | MAT2 (98%) : Example **4** (2%) |
| **4** | 10 nm | MAT3 |
| **3** | 50 nm | MAT4 |
| **2** | 7 nm | HAT-CN |
| **1** | 50 nm | ITO |
| **Substrate** | | Glass |

OLED **D4** yielded an external quantum efficiency (EQE) at 1000 cd/$m^2$ of 11.2%. The emission maximum is at 464 nm with a FWHM of 26 nm at 3.6 V. The corresponding CIEy value is 0.09.

Additional Examples of Organic Molecules of the Invention

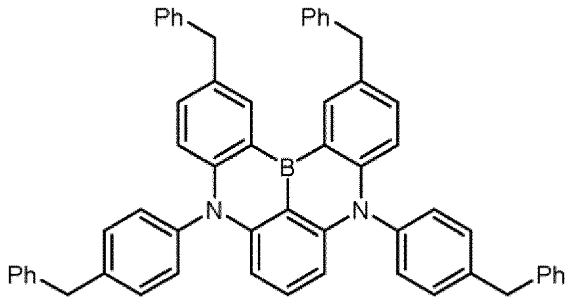

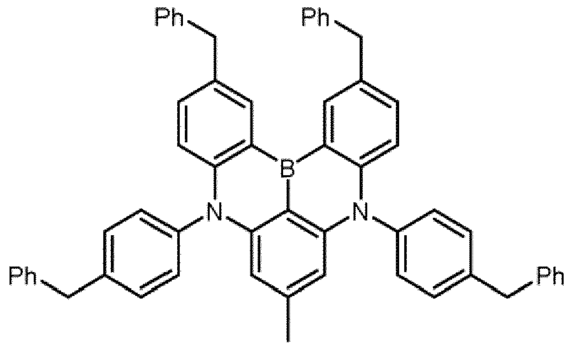

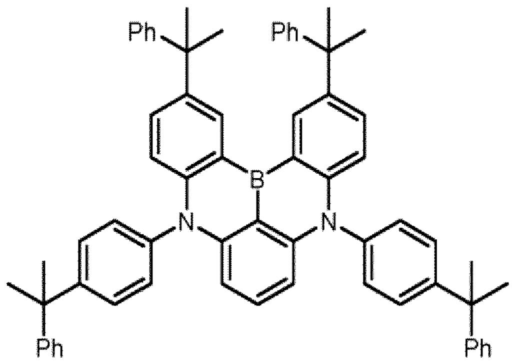

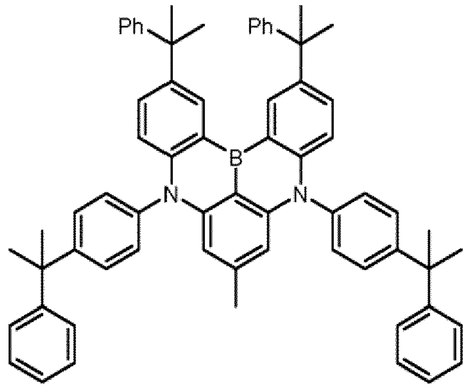

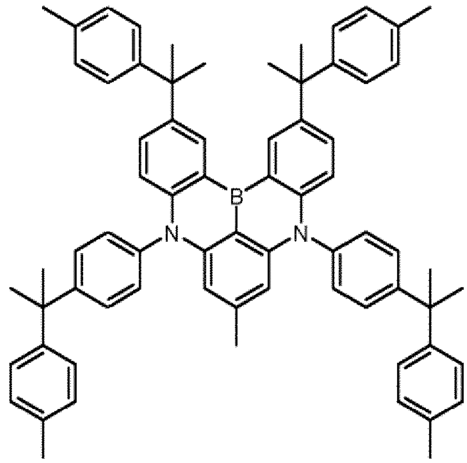

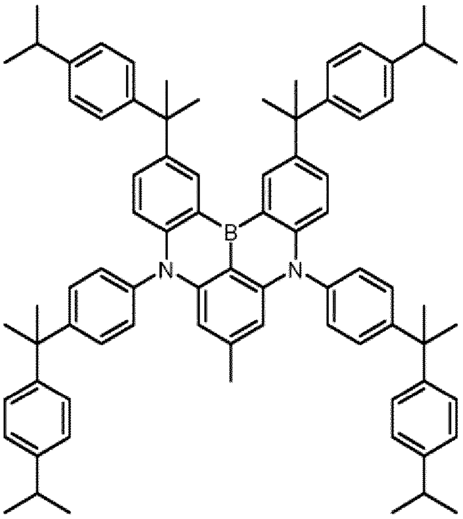

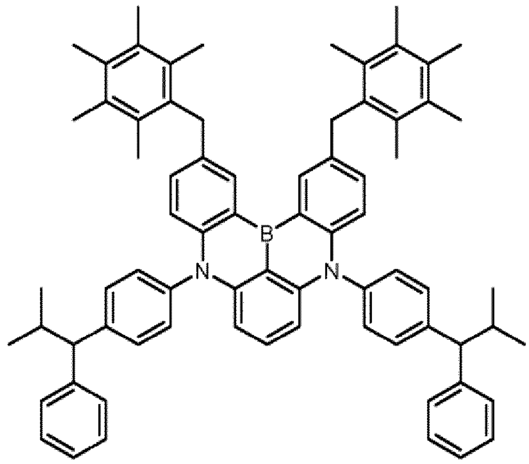

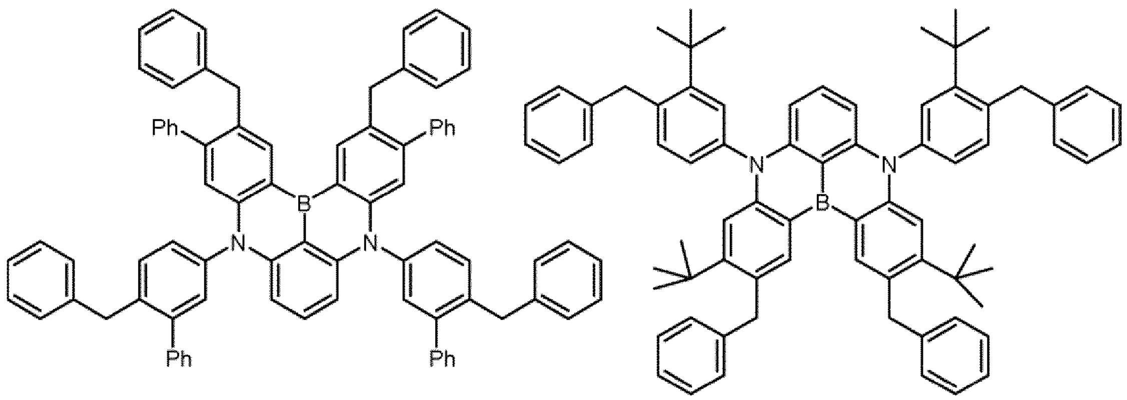

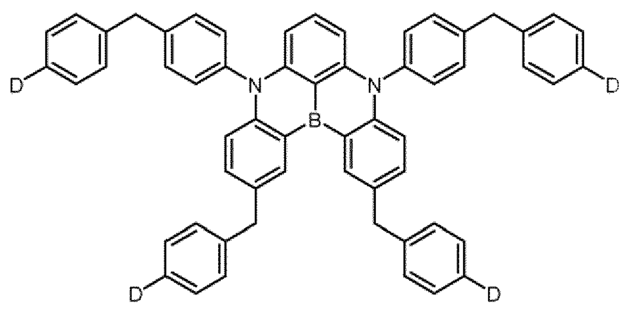

## Claims

**1.** Organic molecule consisting of a structure of formula II-1:

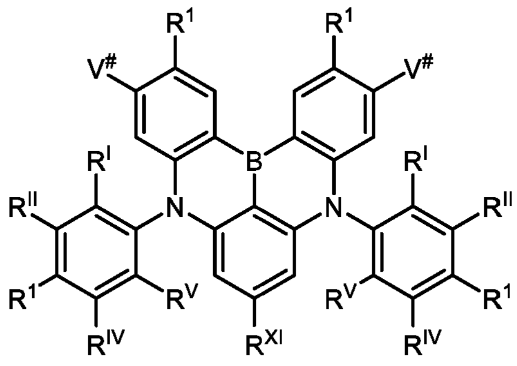

Formula II-1

wherein

$V^{\#}$ is selected from the group consisting of
hydrogen,
deuterium,
$C_1$-$C_5$-alkyl; and
Ph, which is optionally substituted with one or more substituents independently from each other selected from the group consisting of Me, $^{i}$Pr, $^{t}$Bu, and Ph;
wherein
$R^1$ consists of a structure of formula F

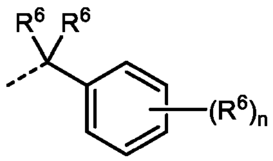

Formula F

wherein n is an integer, which is at each occurrence selected from the group consisting of 0, 1, 2, 3, 4 and 5; and the dotted line representing the position at which it is bonded to the structure shown in formula II-1;
$R^6$ is at each occurrence independently from each other selected from the group consisting of:

hydrogen, deuterium, $C_1$-$C_5$-alkyl;
$R^I$, $R^{II}$, $R^{IV}$, and $R^V$ is independently from another selected from the group consisting of:

$R^1$,
hydrogen,
deuterium,
$N(R^5)_2$,
$OR^5$,
$SR^5$,
$Si(R^5)_3$,
$B(OR^5)_2$,
$OSO_2R^5$,
$CF_3$,
CN,
halogen,
$C_1$-$C_{40}$-alkyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkenyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkynyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,
which is optionally substituted with one or more substituents $R^5$; and
$C_3$-$C_{57}$-heteroaryl,
which is optionally substituted with one or more substituents $R^5$;
$R^5$ is at each occurrence independently from another selected from the group consisting of:

hydrogen, deuterium, OPh, SPh, $CF_3$, CN, F, $Si(C_1$-$C_5$-alkyl$)_3$, $Si(Ph)_3$,
$C_1$-$C_5$-alkyl,
wherein optionally one or more hydrogen atoms are independently from each other substituted by deuterium, CN, $CF_3$, or F;
$C_1$-$C_5$-alkoxy,
wherein optionally one or more hydrogen atoms are independently from each other substituted by deuterium, CN, $CF_3$, or F;
$C_1$-$C_5$-thioalkoxy,
wherein optionally one or more hydrogen atoms are independently from each other substituted by deuterium, CN, $CF_3$, or F;
$C_2$-$C_5$-alkenyl,
wherein optionally one or more hydrogen atoms are independently from each other substituted by deuterium, CN, $CF_3$, or F;
$C_2$-$C_5$-alkynyl,
wherein optionally one or more hydrogen atoms are independently from each other substituted by deuterium, CN, $CF_3$, or F;
$C_6$-$C_{18}$-aryl,
which is optionally substituted with one or more $C_1$-$C_5$-alkyl substituents;
$C_3$-$C_{17}$-heteroaryl,
which is optionally substituted with one or more $C_1$-$C_5$-alkyl substituents;
$N(C_6$-$C_{18}$-aryl$)_2$,
$N(C_3$-$C_{17}$-heteroaryl$)_2$; and
$N(C_3$-$C_{17}$-heteroaryl$)(C_6$-$C_{18}$-aryl$)$; and
$R^{XI}$ is selected from the group consisting of hydrogen, deuterium, chloride and $C_1$-$C_5$ alkyl.

2. Organic molecule according to claim 1, wherein $R^I$, $R^{II}$, $R^{IV}$, and $R^V$ is independently from another selected from the group consisting of:

$R^1$,
hydrogen, deuterium, halogen, Me, $^iPr$, $^tBu$, CN, $CF_3$, $SiMe_3$, $SiPh_3$,
Ph, which is optionally substituted with one or more substituents independently from each other selected from the group consisting of Me, $^iPr$, $^tBu$, CN, $CF_3$, and Ph,
pyridinyl, which is optionally substituted with one or more substituents independently from each other selected from the group consisting of Me, $^iPr$, $^tBu$, CN, $CF_3$, and Ph,
pyrimidinyl, which is optionally substituted with one or more substituents independently from each other selected from the group consisting of Me, $^iPr$, $^tBu$, CN, $CF_3$, and Ph,
carbazolyl, which is optionally substituted with one or more substituents independently from each other selected from the group consisting of Me, $^iPr$, $^tBu$, CN, $CF_3$, and Ph,
triazinyl, which is optionally substituted with one or more substituents independently from each other selected from the group consisting of Me, $^iPr$, $^tBu$, CN, $CF_3$, and Ph,
and $N(Ph)_2$.

3. Organic molecule according to any of claims 1 or 2, wherein $R^6$ is at each occurrence independently from each other selected from the group consisting of:

hydrogen,
deuterium,
Me, $^iPr$, $^tBu$, and neo-pentyl.

4. Organic molecule according to any of claims 1 to 3, wherein $R^6$ is at each occurrence independently from each other selected from the group consisting of:
hydrogen and Me.

5. Organic molecule according to any of claims 1 to 4, wherein $R^I$, $R^{II}$, $R^{IV}$, and $R^V$ is independently from another selected from the group consisting of:

$R^1$, hydrogen, deuterium, Me, $^iPr$, $^tBu$,
Ph, which is optionally substituted with one or more substituents independently from each other selected from the group consisting of Me, $^iPr$, $^tBu$, and Ph,
and $N(Ph)_2$.

6. Organic molecule according to any of claims 1 to 5, wherein $R^I$, $R^{II}$, and $R^{IV}$ is independently from another selected from the group consisting of:
hydrogen, Me, $^tBu$, and Ph.

7. Organic molecule according to any of claims 1 to 6, wherein $R^{XI}$ is selected from the group consisting of hydrogen, Me, $^iPr$ and $^tBu$.

8. Use of an organic molecule according to any of claims 1 to 7 as a luminescent emitter in an optoelectronic device.

9. Use according to claim 8, wherein the optoelectronic device is selected from the group consisting of:

- organic light-emitting diodes (OLEDs),
- light-emitting electrochemical cells,
- OLED-sensors,
- organic diodes,
- organic solar cells,
- organic transistors,
- organic field-effect transistors,
- organic lasers, and
- down-conversion elements.

10. Composition, comprising:

(a) an organic molecule according to any of claims 1 to 7, in particular in the form of an emitter and/or a host, and
(b) an emitter and/or a host material, which differs from the organic molecule, and
(c) optionally, a dye and/or a solvent.

**11.** Optoelectronic device, comprising an organic molecule according to any of claims 1 to 7 or a composition according to claim 10, in particular in the form of a device selected from the group consisting of organic light-emitting diode (OLED), light-emitting electrochemical cell, OLED-sensor, organic diode, organic solar cell, organic transistor, organic field-effect transistor, organic laser, and down-conversion element.

**12.** Optoelectronic device according to claim 11, comprising:

- a substrate,
- an anode, and
- a cathode, wherein the anode or the cathode is disposed on the substrate, and
- a light-emitting layer, which is arranged between the anode and the cathode and which comprises the organic molecule or the composition.

**13.** Method for producing an optoelectronic device, wherein an organic molecule according to any one of claims 1 to 7 or a composition according to claim 10 is used, in particular comprising the processing of the organic molecule by a vacuum evaporation method or from a solution.

**Patentansprüche**

**1.** Organisches Molekül, bestehend aus einer Struktur der Formel II-1:

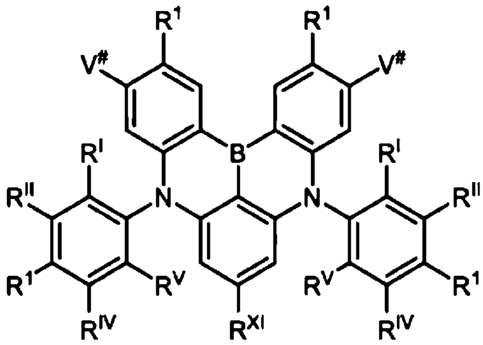

Formel II-1

wobei
$V^{\#}$ aus der Gruppe ausgewählt ist, die aus Folgendem besteht:

Wasserstoff,
Deuterium,
$C_1$-$C_5$-Alkyl; und
Ph, das optional mit einem oder mehreren Substituenten substituiert ist, die unabhängig voneinander aus der Gruppe ausgewählt sind, die aus Me, $^i$Pr, $^t$Bu und Ph besteht;
wobei
$R^1$ aus einer Struktur der Formel F besteht

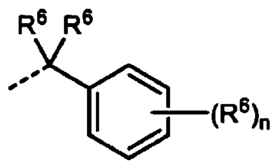

Formel F

wobei n eine ganze Zahl ist, die bei jedem Vorkommen aus der Gruppe ausgewählt ist, die aus 0, 1, 2, 3, 4 und 5 besteht; und wobei die die gestrichelte Linie die Position darstellt, an der es an die in Formel II-1 gezeigte Struktur gebunden ist;
$R^6$ bei jedem Vorkommen unabhängig voneinander aus der Gruppe ausgewählt ist, die aus Wasserstoff, Deuterium, $C_1$-$C_5$-Alkyl besteht;
$R^I$, $R^{II}$, $R^{IV}$ und $R^V$ unabhängig voneinander aus der Gruppe ausgewählt sind, die aus Folgendem besteht:

$R^1$,
Wasserstoff,
Deuterium,
$N(R^5)_2$,
$OR^5$,
$SR^5$,
$Si(R^5)_3$,
$B(OR^5)_2$,
$OSO^2R^5$,
$CF_3$,
CN,
Halogen,
$C_1$-$C_{40}$-Alkyl,
das optional mit einem oder mehreren Substituenten $R^5$ substituiert ist und
wobei eine oder mehrere nicht benachbarte $CH_2$-Gruppen optional durch $R^5C$=$CR^5$, C=C, $Si(R^5)_2$, $Ge(R^5)_2$, $Sn(R^5)_2$, C=O, C=S, C=Se, C=$NR^5$, P(=O)($R^5$), SO, $SO_2$, $NR^5$, O, S oder $CONR^6$ substituiert sind;
$C_1$-$C_{40}$-Alkoxy,
das optional mit einem oder mehreren Substituenten $R^5$ substituiert ist und
wobei eine oder mehrere nicht benachbarte $CH_2$-Gruppen optional durch $R^5C$=$CR^5$, C≡C, $Si(R^5)_2$, $Ge(R^5)_2$, $Sn(R^5)_2$, C=O, C=S, C=Se, C=$NR^5$, P(=O)($R^5$), SO, $SO_2$, $NR^5$, O, S oder $CONR^6$ substituiert sind;
$C_1$-$C_{40}$-Thioalkoxy,
das optional mit einem oder mehreren Substituenten $R^5$ substituiert ist und
wobei eine oder mehrere nicht benachbarte $CH_2$-Gruppen optional durch $R^5C$=$CR^5$, C≡C, $Si(R^5)_2$, $Ge(R^5)_2$, $Sn(R^5)_2$, C=O, C=S, C=Se, C=$NR^5$, P(=O)($R^5$), SO, $SO_2$, $NR^5$, O, S oder $CONR^6$ substituiert sind;
$C_2$-$C_{40}$-Alkenyl,
das optional mit einem oder mehreren Substituenten $R^5$ substituiert ist und
wobei eine oder mehrere nicht benachbarte $CH_2$-Gruppen optional durch $R^5C$=$CR^5$, C≡C, $Si(R^5)_2$, $Ge(R^5)_2$, $Sn(R^5)_2$, C=O, C=S, C=Se, C=$NR^5$, P(=O)($R^5$), SO, $SO_2$, $NR^5$, O, S oder $CONR^6$ substituiert sind;
$C_2$-$C_{40}$-Alkynyl,
das optional mit einem oder mehreren Substituenten $R^5$ substituiert ist und
wobei eine oder mehrere nicht benachbarte $CH_2$-Gruppen optional durch $R^5C$=$CR^5$, C≡C, $Si(R^5)_2$, $Ge(R^5)_2$, $Sn(R^5)_2$, C=O, C=S, C=Se, C=$NR^5$, P(=O)($R^5$), SO, $SO_2$, $NR^5$, O, S oder $CONR^6$ substituiert sind;
$C_6$-$C_{60}$-Aryl,
das optional mit einem oder mehreren Substituenten $R^5$ substituiert ist; und
$C_3$-$C_{57}$-Heteroaryl,
das optional mit einem oder mehreren Substituenten $R^5$ substituiert ist;
$R^5$ bei jedem Vorkommen unabhängig voneinander aus der Gruppe ausgewählt ist, die aus Folgendem besteht:

Wasserstoff, Deuterium, OPh, SPh, $CF_3$, CN, F, $Si(C_1$-$C_5$-Alkyl$)_3$, $Si(Ph)_3$,
$C_1$-$C_5$-Alkyl,
wobei optional ein oder mehrere Wasserstoffatome unabhängig voneinander durch Deuterium, CN, $CF_3$ oder F substituiert sind;
$C_1$-$C_5$-Alkoxy,
wobei optional ein oder mehrere Wasserstoffatome unabhängig voneinander durch Deuterium, CN, $CF_3$ oder F substituiert sind;
$C_1$-$C_5$-Thioalkoxy,
wobei optional ein oder mehrere Wasserstoffatome unabhängig voneinander durch Deuterium, CN, $CF_3$ oder F substituiert sind;
$C_2$-$C_5$-Alkenyl,
wobei optional ein oder mehrere Wasserstoffatome unabhängig voneinander durch Deuterium, CN, $CF_3$

oder F substituiert sind;
$C_2$-$C_5$-Alkynyl,
wobei optional ein oder mehrere Wasserstoffatome unabhängig voneinander durch Deuterium, CN, $CF_3$ oder F substituiert sind;
$C_6$-$C_{18}$-Aryl,
das optional mit einem oder mehreren $C_1$-$C_5$-Alkyl-Substituenten substituiert ist; $C_3$-$C_{17}$-Heteroaryl, das optional mit einem oder mehreren $C_1$-$C_5$-Alkyl-Substituenten substituiert ist; $N(C_6$-$C_{18}$-$Aryl)_2$, $N(C_3$-$C_{17}$-$Heteroaryl)_2$; und
$N(C_3$-$C_{17}$-Heteroaryl)($C_6$-$C_{18}$-Aryl); und
$R^{X1}$ aus der Gruppe ausgewählt ist, die aus Wasserstoff, Deuterium, Chlorid und $C_1$-$C_5$-Alkyl besteht.

**2.** Organisches Molekül nach Anspruch 1, wobei $R^I$, $R^{II}$, $R^{IV}$ und $R^V$ unabhängig voneinander aus der Gruppe ausgewählt sind, die aus Folgendem besteht:

$R^1$,
Wasserstoff, Deuterium, Halogen, Me, $^i$Pr, $^t$Bu, CN, $CF_3$, $SiMe_3$, $SiPh_3$,
Ph, das optional mit einem oder mehreren Substituenten substituiert ist, die unabhängig voneinander aus der Gruppe ausgewählt sind, die aus Me, $^i$Pr, $^t$Bu, CN,
$CF_3$ und Ph besteht,
Pyridinyl, das optional mit einem oder mehreren Substituenten substituiert ist, die unabhängig voneinander aus der Gruppe ausgewählt sind, die aus Me, $^i$Pr, $^t$Bu, CN,
$CF_3$ und Ph besteht,
Pyrimidinyl, das optional mit einem oder mehreren Substituenten substituiert ist, die unabhängig voneinander aus der Gruppe ausgewählt sind, die aus Me, $^i$Pr, $^t$Bu, CN,
$CF_3$ und Ph besteht,
Carbazolyl, das optional mit einem oder mehreren Substituenten substituiert ist, die unabhängig voneinander aus der Gruppe ausgewählt sind, die aus Me, $^i$Pr, $^t$Bu, CN,
$CF_3$ und Ph besteht,
Triazinyl, das optional mit einem oder mehreren Substituenten substituiert ist, die unabhängig voneinander aus der Gruppe ausgewählt sind, die aus Me, $^i$Pr, $^t$Bu, CN,
$CF_3$ und Ph besteht,
und $N(Ph)_2$.

**3.** Organisches Molekül nach einem der Ansprüche 1 oder 2, wobei $R^6$ bei jedem Vorkommen unabhängig voneinander aus der Gruppe ausgewählt ist, die aus Folgendem besteht:

Wasserstoff,
Deuterium,
Me, $^i$Pr, $^t$Bu und Neo-pentyl.

**4.** Organisches Molekül nach einem der Ansprüche 1 bis 3, wobei $R^6$ bei jedem Vorkommen unabhängig voneinander aus der Gruppe ausgewählt ist, die aus Folgendem besteht:
Wasserstoff und Me.

**5.** Organisches Molekül nach einem der Ansprüche 1 bis 4, wobei $R^I$, $R^{II}$, $R^{IV}$ und $R^V$ unabhängig voneinander aus der Gruppe ausgewählt sind, die aus Folgendem besteht:

$R^1$, Wasserstoff, Deuterium, Me, $^i$Pr, $^t$Bu,
Ph, das optional mit einem oder mehreren Substituenten substituiert ist, die unabhängig voneinander aus der Gruppe ausgewählt sind, die aus Me, $^i$Pr, $^t$Bu und Ph besteht,
und $N(Ph)_2$.

**6.** Organisches Molekül nach einem der Ansprüche 1 bis 5, wobei $R^I$, $R^{II}$, $R^{IV}$ und $R^V$ unabhängig voneinander aus der Gruppe ausgewählt sind, die aus Folgendem besteht:
Wasserstoff, Me, $^t$Bu und Ph.

**7.** Organisches Molekül nach einem der Ansprüche 1 bis 6, wobei $R^{XI}$ aus der Gruppe ausgewählt ist, die aus Wasserstoff, Me, $^i$Pr und $^t$Bu besteht.

**8.** Verwendung eines organischen Moleküls nach einem der Ansprüche 1 bis 7 als lumineszierender Emitter in einer optoelektronischen Vorrichtung.

**9.** Verwendung nach Anspruch 8, wobei die optoelektronische Vorrichtung aus der Gruppe ausgewählt ist, die aus Folgendem besteht:

- organischen Leuchtdioden (OLEDs),
- lichtemittierenden elektrochemischen Zellen,
- OLED-Sensoren,
- organischen Dioden,
- organischen Solarzellen,
- organischen Transistoren,
- organischen Feldeffekttransistoren,
- organischen Lasern und
- Abwärtskonversionselementen.

**10.** Zusammensetzung, umfassend

(a) ein organisches Molekül nach einem der Ansprüche 1 bis 7, insbesondere in Form eines Emitters und/oder eines Wirts, und
(b) ein Emitter- und/oder Wirtsmaterial, das sich von dem organischen Molekül unterscheidet, und
(c) optional einen Farbstoff und/oder ein Lösungsmittel.

**11.** Optoelektronische Vorrichtung, umfassend ein organisches Molekül nach einem der Ansprüche 1 bis 7 oder eine Zusammensetzung nach Anspruch 10, insbesondere in Form einer Vorrichtung, ausgewählt aus der Gruppe bestehend aus einer organischen Leuchtdiode (OLED), einer lichtemittierenden elektrochemischen Zelle, einem OLED-Sensor, einer organischen Diode, einer organischen Solarzelle, einem organischen Transistor, einem organischen Feldeffekttransistor, einem organischen Laser und einem Abwärtskonversionselement.

**12.** Optoelektronische Vorrichtung nach Anspruch 11, umfassend:

- ein Substrat,
- eine Anode und
- eine Kathode, wobei die Anode oder die Kathode auf dem Substrat angeordnet ist, und
- eine lichtemittierende Schicht, die zwischen der Anode und der Kathode angeordnet ist und das organische Molekül oder die Zusammensetzung umfasst.

**13.** Verfahren zur Herstellung einer optoelektronischen Vorrichtung, wobei ein organisches Molekül nach einem der Ansprüche 1 bis 7 oder eine Zusammensetzung nach Anspruch 10 verwendet wird, insbesondere umfassend das Verarbeiten des organischen Moleküls durch ein Vakuumverdampfungsverfahren oder aus einer Lösung.

## Revendications

**1.** Molécule organique consistant en une structure de formule II-1 :

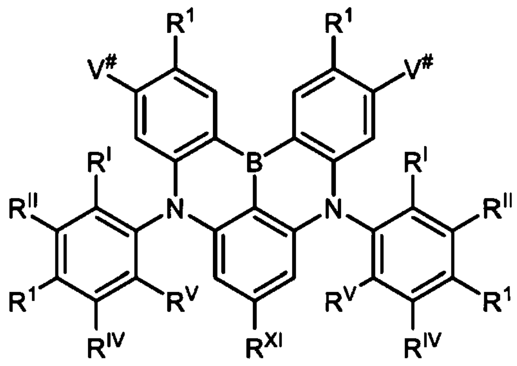

Formule II-1

dans laquelle

$V^{\#}$ est choisi dans le groupe consistant en
hydrogène,
deutérium,
alkyle en $C_1$ à $C_5$; et
Ph, qui est facultativement substitué par un ou plusieurs substituants indépendamment les uns des autres choisis dans le groupe consistant en Me, $^{i}$Pr, $^{t}$Bu et Ph ;
dans laquelle
$R^1$ consiste en une structure de formule F

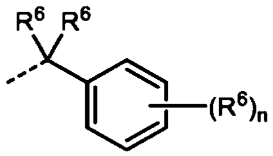

Formule F

dans laquelle n est un entier, qui est, à chaque occurrence, choisi dans le groupe consistant en 0, 1, 2, 3, 4 et 5 ; et la ligne pointillée représentant la position à laquelle il est lié à la structure montrée dans la formule II-1 ;
$R^6$ est, à chaque occurrence indépendamment d'une autre, choisi dans le groupe consistant en :

hydrogène, deutérium, alkyle en $C_1$ à $C_5$;
$R^I$, $R^{II}$, $R^{IV}$ et $R^V$ sont, indépendamment les uns des autres, choisis dans le groupe consistant en :

$R^1$,
hydrogène,
deutérium,
$N(R^5)_2$,
$OR^5$,
$SR^5$,
$Si(R^5)_3$,
$B(OR^5)_2$,
$OSO_2R^5$,
$CF_3$,
CN,
halogène,
alkyle en $C_1$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
alcoxy en $C_1$ à $C_{40}$,

qui est facultativement substitué par un ou plusieurs substituants $R^5$ et
dans lequel un ou plusieurs groupes $CH_2$ non adjacents sont facultativement substitués par $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
thioalcoxy en $C_1$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
alcényle en $C_2$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
alcynyle en $C_2$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
aryle en $C_6$ à $C_{60}$,
qui est facultativement substitué par un ou plusieurs substituants $R^5$ ; et hétéroaryle en $C_3$ à $C_{57}$,
qui est facultativement substitué par un ou plusieurs substituants $R^5$ ;
$R^5$ est, à chaque occurrence indépendamment d'une autre, choisi dans le groupe consistant en :

hydrogène, deutérium, OPh, SPh, $CF_3$, CN, F, Si(alkyle en $C_1$ à $C_5$)$_3$, $Si(Ph)_3$,
alkyle en $C_1$ à $C_5$,
dans lequel facultativement un ou plusieurs atomes d'hydrogène sont, indépendamment les uns des autres, substitués par du deutérium, CN, $CF_3$ ou F ;
alcoxy en $C_1$ à $C_5$,
dans lequel facultativement un ou plusieurs atomes d'hydrogène sont, indépendamment les uns des autres, substitués par du deutérium, CN, $CF_3$ ou F ;
thioalcoxy en $C_1$ à $C_5$,
dans lequel facultativement un ou plusieurs atomes d'hydrogène sont, indépendamment les uns des autres, substitués par du deutérium, CN, $CF_3$ ou F ;
alcényle en $C_2$ à $C_5$,
dans lequel facultativement un ou plusieurs atomes d'hydrogène sont, indépendamment les uns des autres, substitués par du deutérium, CN, $CF_3$ ou F ;
alcynyle en $C_2$ à $C_5$,
dans lequel facultativement un ou plusieurs atomes d'hydrogène sont, indépendamment les uns des autres, substitués par du deutérium, CN, $CF_3$ ou F ;
aryle en $C_6$ à $C_{18}$,
qui est facultativement substitué par un ou plusieurs substituants alkyle en $C_1$ à $C_5$ ; hétéroaryle en $C_3$ à $C_{17}$,
qui est facultativement substitué par un ou plusieurs substituants alkyle en $C_1$ à $C_5$ ;
N(aryle en $C_6$ à $C_{18}$)$_2$ ;
N(hétéroaryle en $C_3$ à $C_{17}$)$_2$, et
N(hétéroaryl en $C_3$ à $C_{17}$)(aryle en $C_6$ à $C_{18}$) ; et
$R^{XI}$ est choisi dans le groupe consistant en hydrogène, deutérium, chlorure et alkyle en $C_1$ à $C_5$.

**2.** Molécule organique selon la revendication 1, dans laquelle $R^I$, $R^{II}$, $R^{IV}$ et $R^V$ sont, indépendamment les uns des autres, choisis dans le groupe consistant en :

$R^1$,
hydrogène, deutérium, halogène, Me, $^iPr$, $^tBu$, CN, $CF_3$, $SiMe_3$, $SiPh_3$,
Ph, qui est facultativement substitué par un ou plusieurs substituants choisis indépendamment les uns des autres dans le groupe consistant en Me, $^iPr$, $^tBu$, CN,
$CF_3$ et Ph,
pyridinyle, qui est facultativement substitué par un ou plusieurs substituants choisis indépendamment les uns des autres dans le groupe consistant en Me, $^iPr$, $^tBu$, CN,
$CF_3$ et Ph ;
pyrimidinyle, qui est facultativement substitué par un ou plusieurs substituants choisis indépendamment les uns des autres dans le groupe consistant en Me, $^iPr$, $^tBu$, CN, $CF_3$ et Ph ;

carbazolyle, qui est facultativement substitué par un ou plusieurs substituants choisis indépendamment les uns des autres dans le groupe consistant en Me, $^{i}$Pr, $^{t}$Bu, CN, $CF_3$ et Ph ;
triazinyle, qui est facultativement substitué par un ou plusieurs substituants choisis indépendamment les uns des autres dans le groupe consistant en Me, $^{i}$Pr, $^{t}$Bu, CN, $CF_3$ et Ph ;
et $N(Ph)_2$.

**3.** Molécule organique selon l'une quelconque des revendications 1 ou 2, dans laquelle $R^6$ est, à chaque occurrence indépendamment d'une autre, choisi dans le groupe consistant en :

hydrogène,
deutérium,
Me, $^{i}$Pr, $^{t}$Bu et néo-pentyle.

**4.** Molécule organique selon l'une quelconque des revendications 1 à 3, dans laquelle $R^6$ est, à chaque occurrence indépendamment d'une autre, choisi dans le groupe consistant en :
hydrogène et Me.

**5.** Molécule organique selon l'une quelconque des revendications 1 à 4, dans laquelle $R^I$, $R^{II}$, $R^{IV}$ et $R^V$ sont, indépendamment les uns des autres, choisis dans le groupe consistant en :

$R^1$, hydrogène, deutérium, Me, $^{i}$Pr, $^{t}$Bu,
Ph, qui est facultativement substitué par un ou plusieurs substituants choisis indépendamment les uns des autres dans le groupe consistant en Me, $^{i}$Pr, $^{t}$Bu et Ph,
et $N(Ph)_2$.

**6.** Molécule organique selon l'une quelconque des revendications 1 à 5, dans laquelle $R^I$, $R^{II}$ et $R^{IV}$ sont, indépendamment les uns des autres, choisis dans le groupe consistant en :
hydrogène, Me, $^{t}$Bu et Ph.

**7.** Molécule organique selon l'une quelconque des revendications 1 à 6, dans laquelle $R^{XI}$ est choisi dans le groupe consistant en hydrogène, Me, $^{i}$Pr et $^{t}$Bu.

**8.** Utilisation d'une molécule organique selon l'une quelconque des revendications 1 à 7 en tant qu'émetteur luminescent dans un dispositif optoélectronique.

**9.** Utilisation selon la revendication 8, dans laquelle le dispositif optoélectronique est choisi dans le groupe consistant en :

• les diodes électroluminescentes organiques (OLED),
• les cellules électrochimiques électroluminescentes,
• les capteurs OLED,
• les diodes organiques,
• les cellules solaires organiques,
• les transistors organiques,
• les transistors à effet de champ organiques,
• les lasers organiques, et
• les éléments de conversion vers le bas.

**10.** Composition, comprenant :

(a) une molécule organique selon l'une quelconque des revendications 1 à 7, en particulier sous la forme d'un émetteur et/ou d'un hôte, et
(b) un émetteur et/ou un matériau hôte, qui diffèrent de la molécule organique, et
(c) facultativement, une teinture et/ou un solvant.

**11.** Dispositif optoélectronique, comprenant une molécule organique selon l'une quelconque des revendications 1 à 7 ou une composition selon la revendication 10, en particulier sous la forme d'un dispositif choisi dans le groupe consistant en une diode électroluminescente organique (OLED), une cellule électrochimique électroluminescente, un capteur

OLED, une diode organique, une cellule solaire organique, un transistor organique, un transistor à effet de champ organique, un laser organique et un élément de conversion vers le bas.

**12.** Dispositif optoélectronique selon la revendication 11, comprenant :

- un substrat,
- une anode et
- une cathode, l'anode ou la cathode étant disposées sur le substrat, et
- une couche électroluminescente, qui est disposée entre l'anode et la cathode et qui comprend la molécule organique ou la composition.

**13.** Procédé de production d'un dispositif optoélectronique, dans lequel une molécule organique selon l'une quelconque des revendications 1 à 7 ou une composition selon la revendication 10 est utilisée, en particulier comprenant le traitement de la molécule organique par un procédé d'évaporation sous vide ou à partir d'une solution.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2020176679 A1
- WO 2021073385 A1
- WO 2021049889 A1
- WO 2021020947 A1
- WO 2021020943 A1
- WO 2021020941 A1
- WO 2020184834 A1


### Non-patent literature cited in the description


- **XIAO LIANG et al.** Peripheral Amplification of Multi-Resonance Induced Thermally Activated Delayed Fluorescence for Highly Efficient OLEDs. *Angewandte Chemie International Edition*, 30 July 2018, vol. 57 (35), 11316-11320
- *CHEMICAL ABSTRACTS*, 51364-51-3
- *CHEMICAL ABSTRACTS*, 13716-12-6 , 0.04
- *CHEMICAL ABSTRACTS*, 13716-12-6
- *CHEMICAL ABSTRACTS*, 594-19-4
- *CHEMICAL ABSTRACTS*, 61676-62-8
- *CHEMICAL ABSTRACTS*, 121-43-7
- *CHEMICAL ABSTRACTS*, 7087-68-5
- *CHEMICAL ABSTRACTS*, 7446-70-0
- *CHEMICAL ABSTRACTS*, 10294-33-4, 2.20
- *CHEMICAL ABSTRACTS*, 81067-41-6
- *CHEMICAL ABSTRACTS*, 3375-31-3
- *CHEMICAL ABSTRACTS*, 564483-18-7
- *CHEMICAL ABSTRACTS*, 103068-20-8
- *CHEMICAL ABSTRACTS*, 831-81-2
- *CHEMICAL ABSTRACTS*, 1135-12-2
- *CHEMICAL ABSTRACTS*, 19230-27-4
- *CHEMICAL ABSTRACTS*, 202925-05-1
- *CHEMICAL ABSTRACTS*, 10081-67-1
- *CHEMICAL ABSTRACTS*, 13061-96-6